# EUROPEAN PATENT APPLICATION

(11) **EP 4 836 657 A1**
(43) Date of publication of application: **04.11.2026**
(21) Application number: 25760743.2
(22) Date of filing: 08.02.2025
(51) Int. Cl.: H10K 59/80, H10K 59/12, H10K 59/121, H10K 59/122, H10K 59/35, H10K 59/38

(54) **DISPLAY PANEL, DISPLAY SCREEN MODULE, AND ELECTRONIC DEVICE**

(30) Priority: 29.02.2024 CN 202410232999
(71) Applicant: Huawei Technologies Co., Ltd., Shenzhen, Guangdong 518129 (CN)
(72) Inventor: YANG, Song, Shenzhen, Guangdong 518129 (CN); CHANG, Yiwen, Shenzhen, Guangdong 518129 (CN); ZHANG, Shixiong, Shenzhen, Guangdong 518129 (CN); LIAO, Feng, Shenzhen, Guangdong 518129 (CN); DOU, Kaihua, Shenzhen, Guangdong 518129 (CN); LIANG, Shuhai, Shenzhen, Guangdong 518129 (CN); ZHU, Ming, Shenzhen, Guangdong 518129 (CN)
(74) Representative: Isarpatent
(86) International application number: PCT/CN2025/076566
(87) International publication number: WO 2025/180199

(57) **Abstract**

Embodiments of the present invention provide a display panel, a display screen module, and an electronic device. The display panel includes a light-emitting layer and a light-absorbing layer, a pixel control circuit and a light-emitting subpixel are disposed in the light-emitting layer, the light-emitting subpixel includes a first light-emitting portion and a second light-emitting portion, and the pixel control circuit is electrically connected to the first light-emitting portion and the second light-emitting portion and can selectively turn on the first light-emitting portion and/or the second light-emitting portion. The light-absorbing layer includes a first light-absorbing portion and a second light-absorbing portion that are spaced apart, the first light-absorbing portion covers a light exit side of the light-emitting layer, a plurality of openings are formed on the first light-absorbing portion, orthographic projections of the plurality of openings in a thickness direction of the display panel cover the first light-emitting portion and the second light-emitting portion, and the second light-absorbing portion is at least partially located on a first side that is of the first light-emitting portion and that is in a first direction perpendicular to the thickness direction, to absorb light that is emitted by the first light-emitting portion on the first side and whose light emission angle is greater than a first light emission angle.

## Description

### CROSS-REFERENCE TO RELATED APPLICATIONS

This application claims priority to Chinese Patent Application No. 202410232999.6, filed with the China National Intellectual Property Administration on February 29, 2024 and entitled "DISPLAY PANEL, DISPLAY SCREEN MODULE, AND ELECTRONIC DEVICE", which is incorporated herein by reference in its entirety.

### TECHNICAL FIELD

Embodiments of the present invention relate to the field of display technologies, and in particular, to a display panel, a display screen module, and an electronic device.

### BACKGROUND

As electronic products such as computers, mobile phones, and tablet computers are increasingly used in people's work and life, great convenience and enjoyment are brought to users. If a display has a wide light emission angle range, information on the screen is vulnerable to prying eyes when a user views the information, exposing personal privacy, trade secrets, or technical information to a risk of leakage. If the display has a narrow light emission angle range, the display is not applicable to a scenario of sharing the display. Therefore, how to enable the display to achieve both anti-peeping and sharing properties becomes a problem to be resolved in the field.

### SUMMARY

Embodiments of the present invention provide a display panel, a display screen module, and an electronic device, so that the display panel has an anti-peeping light-emitting state and a sharing light-emitting state, which can be applied to different scenarios, to separately satisfy respective requirements for anti-peeping and sharing properties in different application scenarios.

According to a first aspect, an embodiment of the present invention provides a display panel. The display panel includes a light-emitting layer and a light-absorbing layer, the light-emitting layer includes a pixel control circuit and a light-emitting subpixel, the light-emitting subpixel includes a first light-emitting portion and a second light-emitting portion, and the pixel control circuit is electrically connected to the first light-emitting portion and the second light-emitting portion to selectively turn on the first light-emitting portion and/or the second light-emitting portion. The light-absorbing layer is located on a light exit side of the light-emitting layer, the light-absorbing layer is provided with a light-absorbing portion, and the light-absorbing portion is at least partially located on a first side that is of the first light-emitting portion and that is in a first direction perpendicular to a thickness direction, to absorb light that is emitted by the first light-emitting portion on the first side and whose emission angle is greater than a first light emission angle.

In the foregoing embodiment, the light-absorbing portion is at least partially located on the first side of the first light-emitting portion in the first direction, and the light-absorbing portion can absorb the light that is emitted by the first light-emitting portion on the first side and whose light emission angle is greater than the first light emission angle, to reduce a visible range of light emitted by the first light-emitting portion on the first side. This helps improve an anti-peeping property of the display panel on the first side.

The display panel selectively turns on the first light-emitting portion and/or the second light-emitting portion by using the pixel control circuit, so that the display panel has at least a first state in which only the first light-emitting portion emits light and a second state in which both the first light-emitting portion and the second light-emitting portion emit light. In the first state, the first light-emitting portion emits light, the second light-emitting portion is turned off, and the visible range of the light emitted by the first light-emitting portion on the first side is narrow. This helps achieve the anti-peeping property of the display panel on the first side. In the second state, both the first light-emitting portion and the second light-emitting portion emit light, and the second light-emitting portion can compensate for the light of the first light-emitting portion on the first side absorbed by the light-absorbing portion, so that the display panel has a wide visible range on the first side. This helps improve a sharing property of the display panel. It can be learned that the display panel can selectively present the first state and the second state to balance the anti-peeping and the sharing properties, to be applicable to different application scenarios.

In some possible implementations, the light-absorbing layer includes a first light-absorbing portion and a second light-absorbing portion, the first light-absorbing portion covers the light exit side of the light-emitting layer, a plurality of openings are formed on the first light-absorbing portion, orthographic projections of the plurality of openings in the thickness direction of the display panel cover the first light-emitting portion and the second light-emitting portion, the second light-absorbing portion is located on a side that is of the first light-absorbing portion and that faces away from the light-emitting layer, and the second light-absorbing portion is at least partially located on the first side of the first light-emitting portion in the first direction, to absorb the light that is emitted by the first light-emitting portion on the first side and whose light emission angle is greater than the first light emission angle.

In the foregoing embodiment, the first light-absorbing portion and the second light-absorbing portion are disposed separately, which helps reduce processing difficulty and ensures position precision and size precision of the first light-absorbing portion and the second light-absorbing portion. In addition, the plurality of openings provided on the first light-absorbing portion correspond to the first light-emitting portion and the second light-emitting portion, to avoid optical paths of the first light-emitting portion and the second light-emitting portion, so that light emitted by the first light-emitting portion and the second light-emitting portion can exit from the first light-absorbing portion, and an exit range of the light is limited. In addition, the first light-absorbing portion can further absorb ambient light emitted into the display panel, to avoid impact of the ambient light on displayed content of the display panel, and improve blackness of the display panel in a screen-off state.

In some possible implementations, the first light emission angle ranges from 30° to 60°. The light-absorbing portion can absorb the light that is emitted by the first light-emitting portion on the first side and that is greater than the first light emission angle, so that a maximum light emission angle of the display panel on the first side is within a range of 30° to 60°, to reduce a light visible range of the display panel on the first side.

In some possible implementations, the second light-absorbing portion is at least partially located on a second side of the first light-emitting portion, to absorb light that is emitted by the first light-emitting portion on the second side and whose emission angle is greater than a second emission angle. The second side and the first side are two opposite sides of the first light-emitting portion in the first direction. For example, the second light emission angle is equal to the first light emission angle, or the second light emission angle is greater than the first light emission angle. When the display panel is in the first state, visible ranges on both sides of the first light-emitting portion in the first direction are narrow. This helps improve the anti-peeping property of the display panel in the first direction. For example, the first direction is a left-right direction of the display panel in a use state. In other words, the display panel has the anti-peeping property in the left-right direction in the first state, and has good privacy.

In some possible implementations, the second light-absorbing portion is at least partially located on a third side of the first light-emitting portion, to absorb light that is emitted by the first light-emitting portion on the third side and whose emission angle is greater than a third emission angle, and/or the second light-absorbing portion is at least partially located on a fourth side of the first light-emitting portion, to absorb light that is emitted by the first light-emitting portion on the fourth side and whose emission angle is greater than a fourth emission angle. The third side and the fourth side are two opposite sides of the first light-emitting portion in a second direction perpendicular to the first direction. For example, both the third emission angle and the fourth emission angle are equal to the first light emission angle.

In some embodiments, the second light-absorbing portion is an annular light-absorbing portion, and an orthographic projection of the annular light-absorbing portion in the thickness direction surrounds the first light-emitting portion. In the embodiments, the display panel has narrow visible ranges in directions surrounding the first light-emitting portion, so that the display panel has a good anti-peeping property. In the embodiments, a shape of the annular light-absorbing portion matches a shape of the first light-emitting portion. For example, in an embodiment in which the first light-emitting portion is a rectangular light-emitting portion, the annular light-absorbing portion is of a rectangular ring structure. In an embodiment in which the first light-emitting portion is a circular light-emitting portion, the annular light-absorbing portion is of a circular ring structure.

In some possible implementations, the first light-emitting portion and the second light-emitting portion are arranged in the first direction. For example, the second light-emitting portion is located on the second side of the first light-emitting portion in the first direction, and the second side and the first side are two opposite sides of the first light-emitting portion.

In some possible implementations, the second light-emitting portion is of an annular structure, and the second light-emitting portion is disposed around the first light-emitting portion. The second light-emitting portion and the first light-emitting portion are more highly integrated and occupy less space. This helps improve resolution of the display panel.

In some possible implementations, the pixel control circuit includes a main control circuit, and a first branch and a second branch that are connected in parallel, an output of the main control circuit is separately electrically connected to an input of the first branch and an input of the second branch, the first light-emitting portion is disposed on the first branch, and a transistor switch and the second light-emitting portion that are connected in series are disposed on the second branch.

In the foregoing embodiment, when the transistor switch on the second branch is turned off, the display panel is in the first state, the main control circuit is connected to the first light-emitting portion, to control the first light-emitting portion to emit light, and the second light-emitting portion is turned off, so that the display panel has the anti-peeping property. When the transistor switch on the second branch is in an on state, the display panel is in the second state, and the main control circuit is separately connected to the first light-emitting portion and the second light-emitting portion, to control both the first light-emitting portion and the second light-emitting portion to emit light, so that the display panel has the sharing property. In addition, because the first branch and the second branch are connected in parallel, in the second state, an input current of the main control circuit is divided on the first branch and the second branch, and brightness of the first light-emitting portion diminishes as a current decreases. This helps prolong a service life of the first light-emitting portion, so that the display panel maintains close display brightness in the first state and the second state.

In some possible implementations, the display panel further includes a packaging layer, and the packaging layer covers the light exit side of the light-emitting layer, to package and protect the light-emitting layer. For example, the display panel further includes a touch layer, the touch layer is located on a light exit side of the packaging layer, the first light-absorbing layer covers a light exit side of the touch layer, and the touch layer is configured to implement a touch function of the display panel.

In some possible embodiments, the light-absorbing layer includes a planarization layer, and the light-absorbing portion is located in the planarization layer. For example, the planarization layer covers a side that is of the first light-absorbing portion and that faces away from the light-emitting layer and a side that is of the second light-absorbing portion and that faces away from the light-emitting layer. The planarization layer can perform planarization processing (or referred to as leveling processing) on a side that is of the light-absorbing layer and that faces away from the light-emitting layer, to facilitate formation of a subsequent structure on a light exit side of the planarization layer.

In some possible implementations, the planarization layer includes a first planarization layer and a second planarization layer, the first planarization layer covers the first light-absorbing portion, the second light-absorbing portion is formed on a light exit side of the first planarization layer, and the second planarization layer covers the second light-absorbing portion. In this way, the first planarization layer enables the side that is of the first light-absorbing portion and that faces away from the light-emitting layer to be a flat surface, to facilitate subsequent formation of the second light-absorbing portion, and the second planarization layer enables a side that is of the second light-absorbing portion and that faces away from the light-emitting layer to be a flat surface, to facilitate disposing of a subsequent structure (for example, a polarizer or a color filter layer).

In some possible implementations, the display panel further includes a polarizer, and the polarizer is located on a light exit side of the light-absorbing layer. The polarizer can be configured to absorb ambient light emitted into the display panel, to prevent reflected ambient light from exiting the display panel and affecting displayed content.

In some possible implementations, the display panel further includes a color filter layer, and the color filter layer is located on a light exit side of the light-absorbing layer, or the color filter layer and the second light-absorbing portion are arranged at a same layer. In this embodiment, a feature of the color filter layer of transmitting light of a specific spectrum and absorbing light of another spectrum is used to suppress ambient light, so that content of the display panel can be clear in a strong light environment such as an outdoor environment.

In some possible implementations, the display panel satisfies the following relationship: $θ 1 \geq arcsin \left(sinα/N\right)$

α is the first light emission angle. For example, the first light emission angle ranges from 30° to 60°. A first critical angle θ1 is an included angle between the thickness direction and a connection line between an end portion that is of the first light-emitting portion and that is away from the second light-absorbing portion in the first direction and an end portion, close to the first light-emitting portion, on an end surface that is of the second light-absorbing portion and that faces away from the light-emitting layer, and N is an average refractive index. The average refractive index N is a ratio of a sine value of an emission angle of light to a sine value of an included angle between the thickness direction and the light in a case in which the light exits from the first light-emitting portion, and reflects a deflection rate of light emitted by the first light-emitting portion after the light exits from a light exit surface. It should be noted that the light emitted by the first light-emitting portion is refracted when passing through a subsequent structural layer (for example, the packaging layer, the touch layer, or the planarization layer). Materials of structural layers are different, and refractive indexes of the structural layers are also different. Therefore, the average refractive index N may be obtained through calculation based on a refractive index of a specific structural layer in the display panel, or the average refractive index N may be obtained through light simulation experiment. For example, in an embodiment in which the display panel includes the packaging layer, the packaging layer is located on a light exit surface of the light-emitting layer, and the average refractive index N is equal to a refractive index of the packaging layer.

The display panel in the foregoing implementations further satisfies the following relationship: $\left(WAP+outBM2\right) / \left(H1\right) > tan \left(θ1\right)$

WAP is a size of the first light-emitting portion in the first direction, outBM2 is a spacing between the first light-emitting portion and the second light-absorbing portion in the first direction, and H1 is a spacing, in the thickness direction, between the first light-emitting portion and an end that is of the second light-absorbing portion and that faces away from the light-emitting layer.

In the foregoing implementations, when light exits from the first light-emitting portion at an angle greater than the first critical angle θ1, all light greater than the first critical angle θ1 is absorbed by the light-absorbing portion. In this case, the light greater than the first critical angle θ1 cannot exit from a light exit surface of the display panel. This eliminates light greater than the first light emission angle on the light exit surface of the display panel, and reduces a visible range of the display panel, to improve the anti-peeping property.

In some possible implementations, the display panel satisfies the following relationship: H1 = H2 + HBM. HBM is a spacing, in the thickness direction, between the end surface that is of the second light-absorbing portion and that faces away from the light-emitting layer and an end surface that is of the first light-absorbing portion and that faces the light-emitting layer. H2 is a spacing, in the thickness direction, between the first light-emitting portion and the end surface that is of the first light-absorbing portion and that faces the light-emitting layer. For example, in an embodiment in which the display panel includes the packaging layer and the touch layer, H2 is a spacing between a light exit surface of the touch layer and the first light-emitting portion in the thickness direction.

In some possible implementations, the display panel further satisfies the following relationship: $θ 2 \geq arcsin \left(sinβ/N\right)$

β is a critical emission angle. When an emission angle of light is greater than the critical emission angle, the light is totally reflected in the display panel and cannot exit from the display panel. Generally, the critical emission angle β is 90°. A second critical angle θ2 is an included angle between the thickness direction and a connection line between an end portion that is of the first light-emitting portion and that is close to the first light-absorbing portion in the first direction and an end portion, away from the first light-emitting portion, on the end surface that is of the first light-absorbing portion and that faces the light-emitting layer, and N is an average refractive index.

The display panel further satisfies the following relationship: $\left(outBM1+WBM1\right) / \left(H2\right) > tan \left(θ2\right)$

outBM 1 is a spacing between the first light-emitting portion and the first light-absorbing portion in the first direction, WBM1 is a size of the first light-absorbing portion in the first direction, and H2 is the spacing, in the thickness direction, between the first light-emitting portion and the end surface that is of the first light-absorbing portion and that faces the light-emitting layer.

In this embodiment, when light that is emitted by the first light-emitting portion and that is greater than the second critical angle θ2 exits into the light exit surface of the display panel, an emission angle corresponding to the light is greater than the critical emission angle. In this case, the light is totally reflected in the display panel and cannot exit from the display panel. This can prevent the light from interfering with display effect of the display panel.

In some possible implementations, the display panel satisfies the following relationship: $θ 3 \geq arcsin \left(sinβ/N\right)$

β is a critical emission angle. For example, β = 90°. A third critical angle θ3 is an included angle between the thickness direction and a connection line between the end portion that is of the first light-emitting portion and that is away from the second light-absorbing portion in the first direction and an end portion, away from the first light-emitting portion, on an end surface that is of the second light-absorbing portion and that faces the light-emitting layer, and N is an average refractive index.

The display panel further satisfies the following relationship: $\left(WAP+outBM2+WBM2\right) / \left(H3\right) > tan \left(θ3\right)$

WAP is the size of the first light-emitting portion in the first direction, outBM2 is the spacing between the first light-emitting portion and the second light-absorbing portion in the first direction, WBM2 is a size of the second light-absorbing portion in the first direction, and H3 is a spacing, in the thickness direction, between the first light-emitting portion and the end surface that is of the second light-absorbing portion and that faces the light-emitting layer.

In this embodiment, when light that is emitted by the first light-emitting portion and that is greater than the third critical angle θ3 exits into the light exit surface of the display panel, an emission angle corresponding to the light is greater than the critical emission angle. In this case, the light is totally reflected in the display panel and cannot exit from the display panel. This can prevent the light from interfering with display effect of the display panel.

In some example implementations, the display panel further satisfies the following relationship: $arctan \left(outBM1/H4\right) \leq arctan \left(\left(outBM2+WBM2\right)/\left(H3\right)\right)$

outBM1 is the spacing between the first light-absorbing portion and the light-absorbing portion in the first direction, outBM2 is the spacing between the second light-absorbing portion and the light-absorbing portion in the first direction, WBM2 is the size of the second light-absorbing portion in the first direction, H3 is the spacing, in the thickness direction, between the first light-emitting portion and the end surface that is of the second light-absorbing portion and that faces the light-emitting layer, and H4 is a spacing, in the thickness direction, between the first light-emitting portion and an end surface that is of the first light-absorbing portion and that faces away from the light-emitting layer.

In this embodiment, when light that is emitted by the first light-emitting portion and that is greater than the third critical angle θ3 exits into the light exit surface of the display panel, an emission angle corresponding to the light is greater than the critical emission angle. In this case, the light is totally reflected in the display panel and cannot exit from the display panel. This can prevent the light from interfering with display effect of the display panel.

In some possible implementations, the display panel further includes a microlens, the microlens is disposed corresponding to the first light-emitting portion and is located on a light exit side of the first light-emitting portion, and an orthographic projection of the microlens in the thickness direction at least partially overlaps the first light-emitting portion. The microlens converges the light emitted by the first light-emitting portion corresponding to the microlens, so that the light can be more concentrated. This helps the light exit from the light-absorbing layer, to improve light exit efficiency of the light emitted by the first light-emitting portion.

In some possible implementations, the first light-absorbing portion is located on a light exit side of the microlens, and light emitted by the first light-emitting portion can first be converged by the microlens and then pass through the light-absorbing layer. It is easier for the converged light to pass through the light-absorbing layer, so that light exit efficiency is improved.

In some possible implementations, the microlens and the first light-absorbing portion are arranged at a same layer, and the microlens is located in the opening that is on the first light-absorbing portion and that corresponds to the first light-emitting portion. In this embodiment, the microlens can converge light, and the microlens does not occupy a separate structural layer. This helps simplify a structure of the display panel.

In some possible implementations, the microlens is located on the side that is of the first light-absorbing portion and that faces away from the light-emitting layer, and the second light-absorbing portion is located on the light exit side of the microlens.

In some possible implementations, a plurality of light-emitting subpixels include a red light-emitting subpixel, a green light-emitting subpixel, and a blue light-emitting subpixel, and the display panel includes a plurality of pixel groups. Each pixel group includes one red light-emitting subpixel, one green light-emitting subpixel, and one blue light-emitting subpixel that are arranged in a triangle, or each pixel group includes one red light-emitting subpixel, two green light-emitting subpixels, and one blue light-emitting subpixel that are arranged in a quadrilateral.

According to a second aspect, an embodiment of the present invention provides a manufacturing method for a display panel. The manufacturing method includes:
forming a light-emitting layer, where the light-emitting layer includes a pixel control circuit and a light-emitting subpixel, the light-emitting subpixel includes a first light-emitting portion and a second light-emitting portion, and the pixel control circuit is electrically connected to the first light-emitting portion and the second light-emitting portion to selectively turn on the first light-emitting portion and/or the second light-emitting portion; and
forming a light-absorbing layer, where the light-absorbing layer is disposed on a light exit side of the light-emitting layer, the light-absorbing layer includes a first light-absorbing portion and a second light-absorbing portion, a plurality of openings are formed on the first light-absorbing portion, orthographic projections of the plurality of openings in a thickness direction of the display panel cover the first light-emitting portion and the second light-emitting portion, the second light-absorbing portion is located on a side that is of the first light-absorbing portion and that faces away from the light-emitting layer, and the second light-absorbing portion is at least partially located on a first side that is of the first light-emitting portion and that is in a first direction perpendicular to the thickness direction, to absorb light that is emitted by the first light-emitting portion on the first side and whose light emission angle is greater than a first light emission angle.

For example, forming the light-emitting layer specifically includes: forming a pixel drive circuit on a substrate, forming a pixel definition layer by using a vapor deposition process, and forming the light-emitting subpixel on the pixel definition layer.

For example, after forming the light-emitting layer, the manufacturing method further includes: forming a packaging layer on the light exit side of the light-emitting layer, and forming a touch layer on a light exit side of the packaging layer.

For example, forming the light-absorbing layer specifically includes: manufacturing the light-absorbing layer by using a coating and photolithography process. The first light-absorbing portion is manufactured by using the coating and photolithography process, a light exit side of the touch layer and a light exit side of the first light-absorbing portion are coated with a first planarization layer, the second light-absorbing portion is manufactured on a light exit side of the first planarization layer by using the coating and photolithography process, and light exit sides of the second light-absorbing portion and the first planarization layer are coated with a second planarization layer.

For example, the manufacturing method further includes: sequentially attaching a polarizer and a cover to a light exit side of the light-absorbing layer.

According to a third aspect, an embodiment of the present invention provides a display screen module, including the display panel in any one of the foregoing possible implementations and a flexible circuit board. The flexible circuit board is electrically connected to the display panel.

According to a fourth aspect, an embodiment of the present invention provides an electronic device, including a control circuit board and the display screen module in any one of the foregoing possible implementations. The flexible circuit board in the display screen module is configured to connect the control circuit board to the display panel.

### BRIEF DESCRIPTION OF DRAWINGS

FIG. 1 is a diagram of a structure of an electronic device according to an embodiment of the present invention;
FIG. 2 is a diagram of a structure of a display panel according to Embodiment 1 of the present invention;
FIG. 3 is a diagram of a structure of a first light-absorbing portion of the display panel according to Embodiment 1 of the present invention;
FIG. 4 is a diagram of a structure of a second light-absorbing portion of the display panel according to Embodiment 1 of the present invention;
FIG. 5 is a diagram of a partial structure of a display panel cut in a thickness direction according to an embodiment of the present invention;
FIG. 6 is a diagram of another partial structure of a display panel cut in a thickness direction according to an embodiment of the present invention;
FIG. 7 is a diagram of another partial structure of a display panel cut in a thickness direction according to an embodiment of the present invention;
FIG. 8 is a diagram of another partial structure of a display panel cut in a thickness direction according to an embodiment of the present invention;
FIG. 9 is a diagram of another partial structure of a display panel cut in a thickness direction according to an embodiment of the present invention;
FIG. 10 is a diagram of still another partial structure of a display panel cut in a thickness direction according to an embodiment of the present invention;
FIG. 11 is a diagram of yet another partial structure of a display panel cut in a thickness direction according to an embodiment of the present invention;
FIG. 12 is a schematic of a circuit structure of a pixel control circuit of a display panel according to an embodiment of the present invention;
FIG. 13 is a diagram of a structure of a display panel according to Embodiment 2 of the present invention;
FIG. 14 is a diagram of a structure of a display panel according to Embodiment 3 of the present invention;
FIG. 15 is a diagram of a structure of a display panel according to Embodiment 4 of the present invention;
FIG. 16 is a diagram of a structure of a display panel according to Embodiment 5 of the present invention;
FIG. 17 is a diagram of a structure of a display panel according to Embodiment 6 of the present invention;
FIG. 18 is a diagram of a structure of a display panel according to Embodiment 7 of the present invention;
FIG. 19 is a diagram of a structure of a display panel according to Embodiment 8 of the present invention;
FIG. 20 is a diagram of a structure of a display panel according to Embodiment 9 of the present invention;
FIG. 21 is a diagram of a structure of a display panel according to Embodiment 10 of the present invention; and
FIG. 22 is a diagram of a structure of a display panel according to Embodiment 11 of the present invention.

### DESCRIPTION OF EMBODIMENTS

To make the objectives, technical solutions, and advantages of the present invention clearer, the following further describes implementations of the present invention in detail with reference to the accompanying drawings.

The following terms "first", "second", and the like are merely used for ease of description, but shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In embodiments of this application, unless otherwise specified and limited, the term "electrical connection" may be direct electrical connection, or may be indirect electrical connection through an intermediate medium.

In embodiments of this application, an expression such as "example" or "for example" is used to represent giving an example, an illustration, or a description. Any embodiment or design scheme described as an "example" or "for example" in embodiments of this application shall not be explained as being more preferred or having more advantages than another embodiment or design scheme. Exactly, use of the expression such as "example" or "for example" is intended to present a related concept in a specific manner.

In embodiments of this application, "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects.

In embodiments of this application, for example, on, under, left, right, front, and rear are relative direction indications used to explain structures and movement of different parts in this application. These indications are appropriate when the parts are in positions shown in the figure. However, if descriptions of the positions of the parts change, these direction indications correspondingly change. It should be further noted that a same reference numeral in embodiments of this application represents a same component or a same part or component. For a same part or component in embodiments of this application, only one part or component may be marked with a reference numeral as an example in the figure. It should be understood that, for another same part or component, the reference numeral is also applicable.

An embodiment of this application provides an electronic device. The electronic device may be a device such as a mobile phone, a tablet computer (tablet personal computer), a laptop computer (laptop computer), a personal digital assistant (personal digital assistant, PDA), a camera, a personal computer, a notebook computer, a vehicle-mounted device, a wearable device, a watch, augmented reality (augmented reality, AR) glasses, an AR helmet, virtual reality (virtual reality, VR) glasses, or a VR helmet. For example, the electronic device may be a portable personal computer.

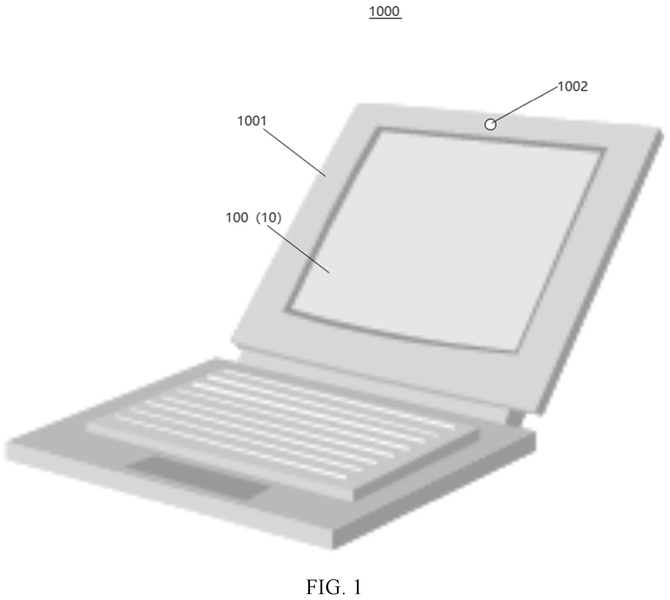

FIG. 1 is a diagram of a structure of an electronic device 1000 according to an embodiment of this application. In the embodiment shown in FIG. 1, the electronic device 1000 is a personal computer. For example, the electronic device 1000 may include a display screen module 100, the display screen module 100 includes a display panel 1, and the display panel 10 may receive an electrical signal and optically display information for a user to view. In some other embodiments, the display panel 10 is integrated with a touch module, and the user may perform a touch operation on the display panel 10 to implement information input or implement a specific function.

In some embodiments, the electronic device 1000 further includes components such as a back housing 1001, a control circuit board (not shown), a battery (not shown), and a camera. For example, the display panel 10 and the back housing 1001 are combined to jointly form an outer contour of the electronic device 1000. The back housing 1001 is configured to protect an internal electronic component (such as a circuit board or the battery) of the electronic device 1000. In some embodiments, the back housing 1001 includes a back cover and a middle frame, and the middle frame is fastened to the back cover. For example, the middle frame is fastened to the back cover by using an adhesive. Alternatively, the middle frame and the back cover are integrally formed. In other words, the middle frame and the back cover are an integral structure. The display panel 10 is connected to the middle frame in a manner such as bonding. Space formed by the display panel 10, the middle frame, and the back cover accommodates a component such as a circuit board. The circuit board may include a flexible circuit board, a rigid circuit board, or the like. A power device such as a chip or a controller may be disposed on the circuit board.

In some embodiments, the electronic device 1000 further includes a camera 1002, a camera hole is provided on the back housing 1001, and the camera 1002 can obtain image information on a light exit side of the display panel 10 through the camera hole. In some other examples, the electronic device 1000 is directly connected to an external power supply for use without a need to dispose a battery. It may be understood that FIG. 1 merely schematically shows some components of the electronic device 1000. Actual shapes, actual sizes, actual positions, and actual structures of these components are not limited by FIG. 1 and the following accompanying drawings.

An embodiment of this application further provides a display screen module 100. The display screen module 100 includes a display panel 10 and a flexible circuit board (not shown). The flexible circuit board is electrically connected to the display panel 10, to provide an electrical signal for the display panel 10. For example, a first end of the flexible circuit board is electrically connected to the display panel 10, another end of the flexible circuit is provided with a connector, and the connector is configured to be in insertion connection to an external controller or an external power supply, to facilitate installation and detachment of the display screen module 100. In an embodiment in which the display screen module 100 is used in the electronic device 1000, the flexible circuit board of the display screen module 100 may be connected between the display panel 10 and the control circuit board of the electronic device 1000, to implement signal transmission.

For example, the display panel 10 is any one of an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro organic light-emitting diode) display, a micro organic light-emitting diode (micro organic light-emitting diode) display, a quantum dot light-emitting diode (quantum dot light-emitting diode, QLED) display, and a liquid crystal display (liquid crystal display, LCD). For example, the display panel 10 is an OLED display panel. The OLED display panel has many advantages, such as lightness and thinness, high contrast, a high response speed, and flexibility and foldability.

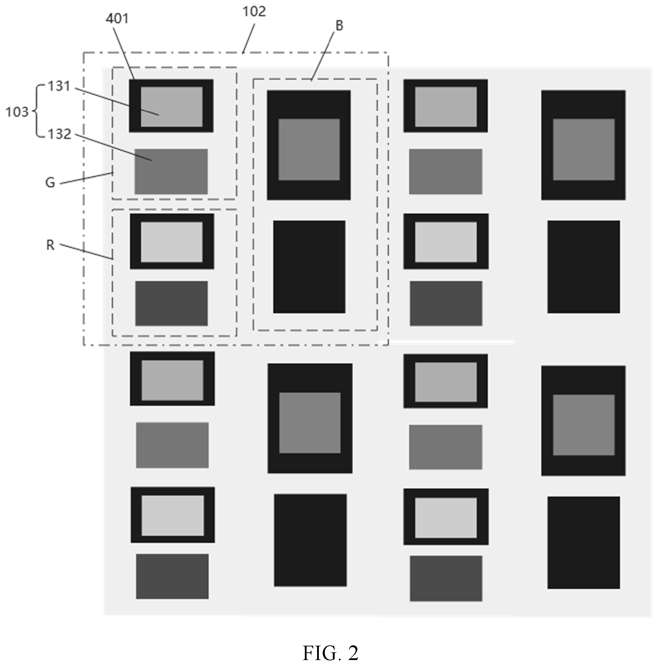

The display panel 10 implements display of a plurality of colors based on a three-color ratio. The three-color ratio specifically means that three primary colors, namely, red, green, and blue, are superimposed at different ratios to be displayed as different colors. In some embodiments, the display panel 10 uses a red-green-blue (red-green-blue, RGB) color mode. To be specific, the display panel includes a plurality of red light-emitting subpixels R (which can emit red light), a plurality of green light-emitting subpixels G (which can emit green light), and a plurality of blue light-emitting subpixels B (which can emit blue light) that are spaced apart. FIG. 2 is a diagram of a structure of a display panel in an implementation. The display panel in this embodiment uses an RGB color mode. In the color mode, a plurality of light-emitting subpixels 103 can emit light of different colors with different brightness respectively. Because a size of each light-emitting subpixel 103 is very small, the light emitted by the plurality of light-emitting subpixels 103 is mixed into mixed light of a specific color within a visual range perceptible to human eyes. In addition, in some other embodiments, the display panel 100 uses a red-green-blue-white (red-green-blue-white, RGBW) color mode. To be specific, the display panel includes a red light subpixel R (which can emit red light), a green light subpixel G (which can emit green light), a blue light subpixel B (which can emit blue light), and a white light subpixel W (which can emit white light) that are spaced apart. Details are not described herein.

Light in the display panel 10 exits from a light exit surface of the display panel 10, and an included angle between the exit light and a normal perpendicular to the light exit surface is a light emission angle. A maximum light emission angle of the display panel 10 is a maximum included angle between the exit light exiting from the light exit surface of the display panel 10 and the normal perpendicular to the light exit surface. The maximum light emission angle can reflect a visible range of the display panel 10. In other words, a user can view displayed content from the front of the display panel 10 in a direction perpendicular to the light exit surface, and the user can still view the content on the display panel 10 when there is a line-of-sight included angle between a line of sight of the user and the normal perpendicular to the light exit surface and the line-of-sight included angle is less than the maximum light emission angle of the display panel 10. In a scenario in which the maximum light emission angle of the display panel 10 is large, for example, the maximum light emission angle of the display panel 10 is greater than or equal to 70°, when the line-of-sight included angle between the line of sight of the user and the normal perpendicular to the light exit surface is within a range of less than 70°, the user can clearly view the displayed content on the display panel 10. In this case, the display panel 10 has a wide visible range, which facilitates simultaneous viewing the display panel 10 by two or more users, to implement sharing of the display panel 10. However, the display panel 10 has a poor anti-peeping property, and information is vulnerable to prying eyes when the user views the information, exposing personal privacy, trade secrets, or technical information to a risk of leakage. In a scenario in which the maximum light emission angle of the display panel 10 is small, the display panel 10 has a narrow visible range, leading to a poor sharing property.

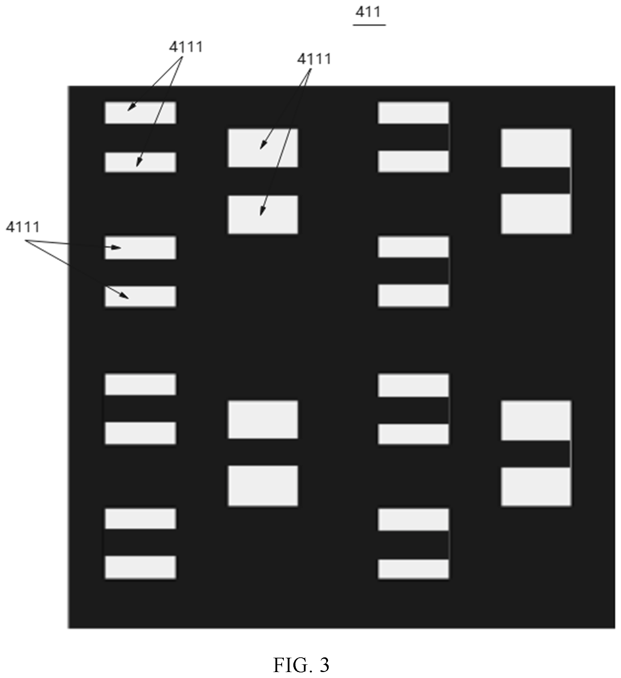

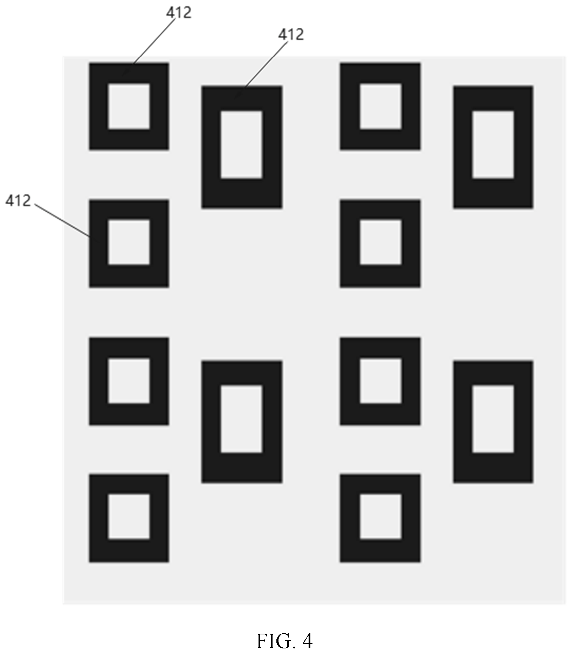

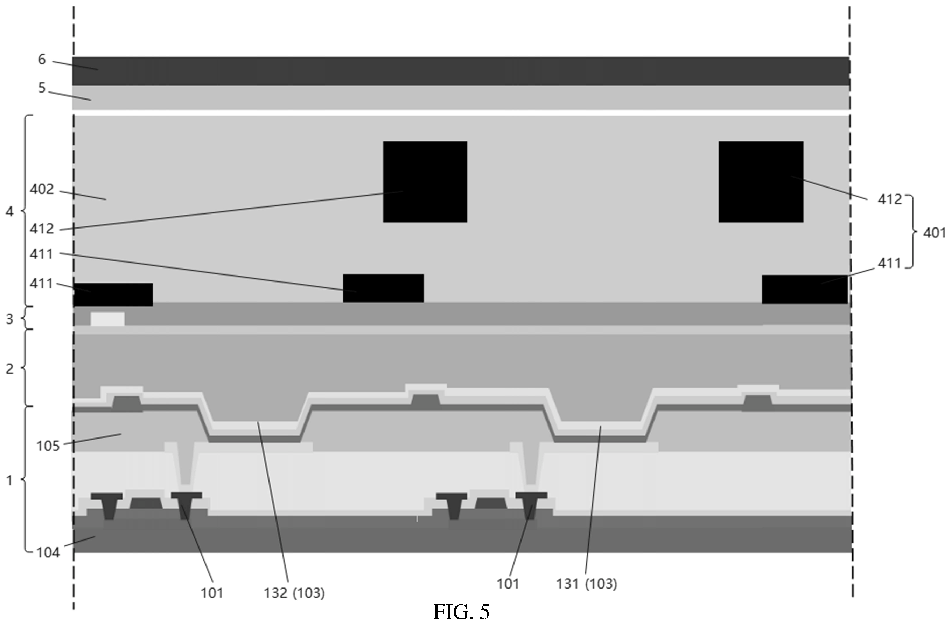

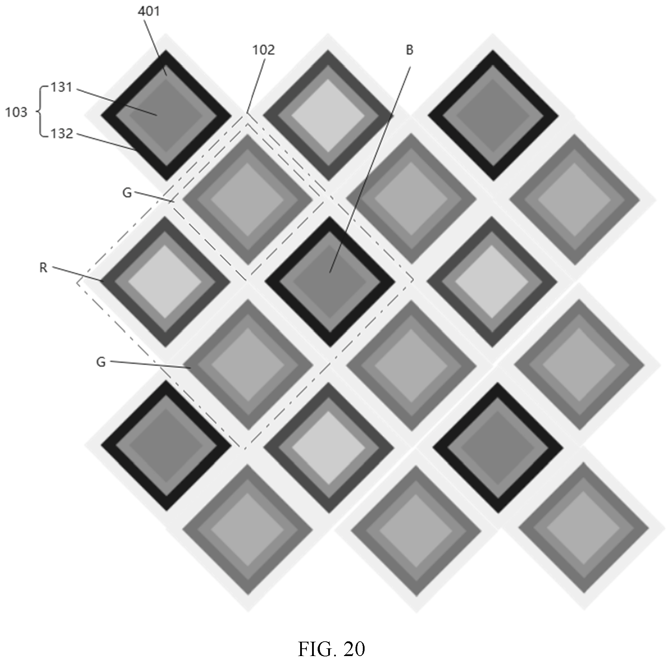

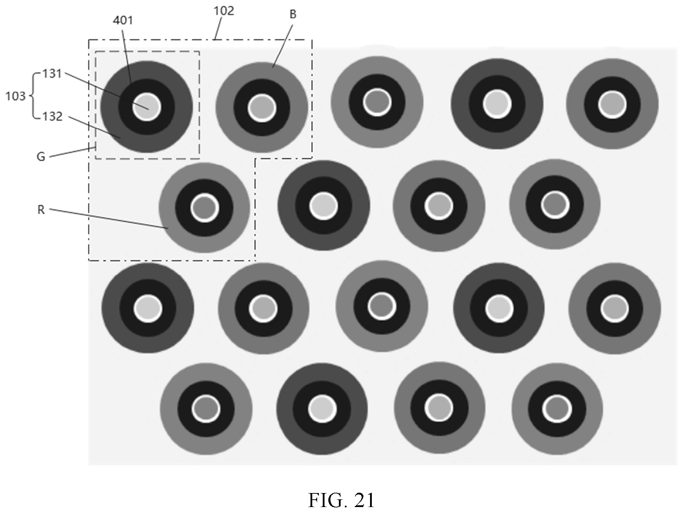

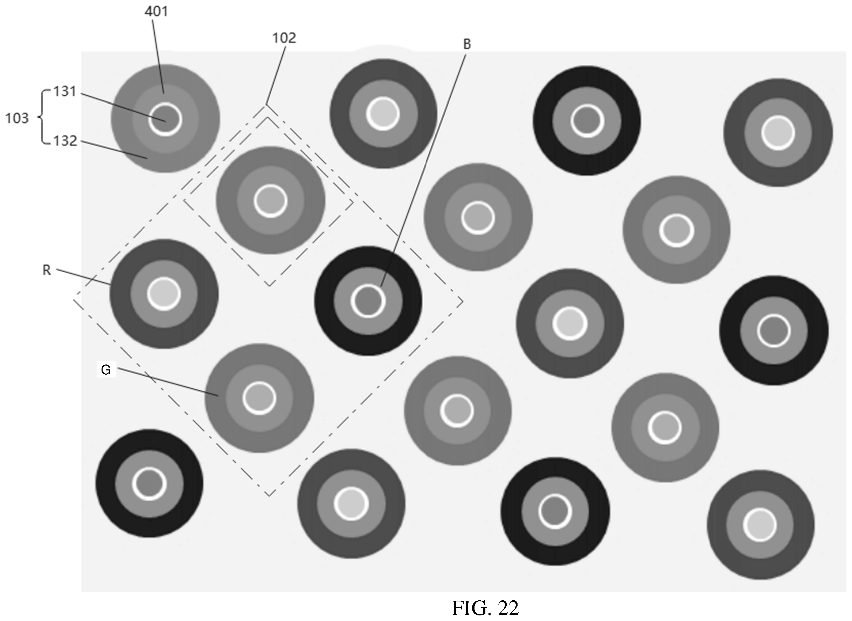

Based on this, as shown in FIG. 2 to FIG. 22, embodiments of this application provide a display panel 10. FIG. 2 is a diagram of a structure of the display panel 10 according to an example embodiment of this application. FIG. 5 to FIG. 11 are sectional views of the display panel 10 according to different example implementations of this application. It should be noted that FIG. 5 to FIG. 11 are merely examples of diagrams of partial structures of the display panel 10 cut in a thickness direction according to different embodiments. During actual application, the display panel 10 includes one or more partial structures of the display panel 10 shown in any one of the embodiments in FIG. 5 to FIG. 11. In addition, the display panel 10 further includes another structure that is not shown in the accompanying drawings of this application. For example, the display panel 10 may further include a packaging frame, a frame adhesive layer, and the like. This is not specifically limited in this application.

In embodiments of this application, the display panel 10 includes a light-emitting layer 1 and a light-absorbing layer 4, the light-emitting layer 1 includes a pixel control circuit 101 and a light-emitting subpixel 103, the light-emitting subpixel 103 includes a first light-emitting portion 131 and a second light-emitting portion 132, and the pixel control circuit 101 is electrically connected to the first light-emitting portion 131 and the second light-emitting portion 132 to selectively turn on the first light-emitting portion 131 and/or the second light-emitting portion 132. The light-absorbing layer 4 is located on a light exit side of the light-emitting layer 1, the light-absorbing layer 4 is provided with a light-absorbing portion 401, an orthographic projection of the light-absorbing portion 401 in the thickness direction of the display panel 10 is staggered with the first light-emitting portion 131 and the second light-emitting portion 132 on the light-emitting layer 1, and the light-absorbing portion 401 is at least partially located on a first side that is of the first light-emitting portion 131 and that is in a first direction perpendicular to the thickness direction, to absorb light that is emitted by the first light-emitting portion 131 on the first side and whose light emission angle is greater than a first light emission angle.

In the foregoing embodiments, the light-absorbing portion 401 is at least partially located on the first side of the first light-emitting portion 131 in the first direction, and the light-absorbing portion 401 can absorb the light that is emitted by the first light-emitting portion 131 on the first side and whose light emission angle is greater than the first light emission angle, to reduce a visible range of light emitted by the first light-emitting portion 131 on the first side. This helps improve an anti-peeping property of the display panel 10 on the first side.

The display panel 10 selectively turns on the first light-emitting portion 131 and/or the second light-emitting portion 132 by using the pixel control circuit 101, so that the display panel 10 has at least a first state in which only the first light-emitting portion 131 emits light and a second state in which both the first light-emitting portion 131 and the second light-emitting portion 132 emit light. In the first state, the first light-emitting portion 131 emits light, the second light-emitting portion 132 is turned off, and the visible range of the light emitted by the first light-emitting portion 131 on the first side is narrow. This helps achieve the anti-peeping property of the display panel 10 on the first side. In the second state, both the first light-emitting portion 131 and the second light-emitting portion 132 emit light, and the second light-emitting portion 132 can compensate for light of the first light-emitting portion 131 on the first side absorbed by the light-absorbing portion 401, so that the display panel 10 has a wide visible range on the first side. This helps improve a sharing property of the display panel 10. It can be learned that the display panel 10 can selectively present the first state and the second state to balance the anti-peeping and the sharing properties, to be applicable to different application scenarios.

In some embodiments, the light-absorbing layer 4 includes a first light-absorbing portion 411 and a second light-absorbing portion 412, the first light-absorbing portion 411 covers the light exit side of the light-emitting layer 1, a plurality of openings 4111 are formed on the first light-absorbing portion 411, orthographic projections of the plurality of openings 4111 in the thickness direction of the display panel 10 cover the first light-emitting portion 131 and the second light-emitting portion 132, the second light-absorbing portion 412 is located on a side that is of the first light-absorbing portion 411 and that faces away from the light-emitting layer 1, and the second light-absorbing portion 412 is at least partially located on the first side of the first light-emitting portion 131 in the first direction, to absorb the light that is emitted by the first light-emitting portion 131 on the first side and whose light emission angle is greater than the first light emission angle.

As shown in FIG. 2 to FIG. 4, in the embodiments, the first light-absorbing portion 411 and the second light-absorbing portion 412 in the light-absorbing layer 4 are spaced apart in the thickness direction. In comparison with an embodiment in which light-absorbing portions are integrally formed, the first light-absorbing portion 411 and the second light-absorbing portion 412 each have a smaller size in the thickness direction. This helps reduce processing difficulty, and ensures position precision and size precision of the first light-absorbing portion 411 and the second light-absorbing portion 412. In addition, the plurality of openings 4111 provided on the first light-absorbing portion 411 correspond to the first light-emitting portion 131 and the second light-emitting portion 132, to avoid optical paths of the first light-emitting portion 131 and the second light-emitting portion 132, so that light emitted by the first light-emitting portion 131 and the second light-emitting portion 132 can exit from the first light-absorbing portion 411, and an exit range of the light is limited. In addition, the first light-absorbing portion 411 can further absorb ambient light emitted into the display panel 10, to avoid impact of the ambient light on displayed content of the display panel 10, and improve blackness of the display panel 10 in a screen-off state.

For example, the first light emission angle ranges from 30° to 60°. In this way, the light-absorbing portion 401 can absorb light that is emitted by the first light-emitting portion 131 on the first side and that is greater than the first light emission angle, so that a maximum light emission angle of the display panel 10 on the first side is within a range of 30° to 60°, to reduce a light visible range of the display panel 10 on the first side.

In an example application scenario, the display panel 10 is used in a portable personal computer. For example, the first direction of the display panel 10 is a left-right direction of the computer in a use state, that is, a left-right direction of the display panel 10 facing a user. In this case, when the display panel 10 is in the first state, the user may view the content on the display panel 10 from the front of the display panel 10, and the visible range of the display panel 10 on the first side is narrow, so that the display panel 10 has the anti-peeping property on the first side. When using the computer, the user may orient the first side of the display panel 10 toward a public environment, to improve privacy during use. When the user needs to view the content with others, the display panel 10 is in the second state, both the first light-emitting portion 131 and the second light-emitting portion 132 emit light, and the second light-emitting portion 132 can compensate for the light of the first light-emitting portion 131 on the first side that is absorbed by the light-absorbing portion 401 and that is greater than the first light emission angle, so that the visible range on the first side is wider. This helps achieve the sharing property of the display panel 10.

In some embodiments, the second light-absorbing portion 412 is at least partially located on a second side of the first light-emitting portion 131, to absorb light that is emitted by the first light-emitting portion 131 on the second side and whose emission angle is greater than a second emission angle. The second side and the first side are two opposite sides of the first light-emitting portion 131 in the first direction. For example, the second light emission angle is equal to the first light emission angle, or the second light emission angle is greater than the first light emission angle. In the embodiments, when the display panel 10 is in the first state, visible ranges on both sides of the first light-emitting portion 131 in the first direction are narrow. This helps improve the anti-peeping property of the display panel 10 in the first direction.

In some embodiments, the second light-absorbing portion 412 is at least partially located on a third side of the first light-emitting portion 131, to absorb light that is emitted by the first light-emitting portion 131 on the third side and whose emission angle is greater than a third light emission angle. For example, the second light-absorbing portion 412 is at least partially located on a fourth side of the first light-emitting portion 131, to absorb light that is emitted by the first light-emitting portion 131 on the fourth side and whose emission angle is greater than a fourth light emission angle. The third side and the fourth side are two opposite sides of the first light-emitting portion 131 in a second direction perpendicular to the first direction. For example, both the third light emission angle and the fourth light emission angle are equal to the first light emission angle.

In some embodiments, as shown in FIG. 2, the second light-absorbing portion 412 is an annular light-absorbing portion, and an orthographic projection of the annular light-absorbing portion in the thickness direction surrounds the first light-emitting portion 131. In the embodiments, the display panel 10 has narrow visible ranges in directions surrounding the first light-emitting portion 131, so that the display panel 10 has a good anti-peeping property.

In the foregoing embodiments, a shape of the annular light-absorbing portion matches a shape of the first light-emitting portion 131. For example, in an embodiment in which the first light-emitting portion 131 is a rectangular light-emitting portion, the annular light-absorbing portion is of a rectangular ring structure. In an embodiment in which the first light-emitting portion 131 is a circular light-emitting portion, the annular light-absorbing portion is of a circular ring structure.

In some possible implementations, the first light-emitting portion 131 and the second light-emitting portion 132 are arranged in the first direction. For example, the first light-emitting portion 131 and the second light-emitting portion 132 are of a same or similar structure, for example, both are circular light-emitting portions or rectangular light-emitting portions. In some embodiments, the second light-emitting portion 132 is located on the second side of the first light-emitting portion 131 in the first direction, and the second side and the first side are two opposite sides of the first light-emitting portion 131.

In some possible implementations, the second light-emitting portion 132 is of an annular structure, and the second light-emitting portion 132 is disposed around the first light-emitting portion 131. In the embodiments, the second light-emitting portion 132 and the first light-emitting portion 131 are more highly integrated and occupy less space. This helps improve resolution of the display panel 10. For example, the first light-emitting portion 131 is a rectangular light-emitting portion, and the second light-emitting portion 132 is of a rectangular ring structure. Alternatively, the first light-emitting portion 131 is a circular light-emitting portion, and the second light-emitting portion 132 is of a circular ring structure.

In some embodiments, the display panel 10 is an OLED display panel, and both the first light-emitting portion 131 and the second light-emitting portion 132 are organic light-emitting diodes (Organic Light-Emitting Diodes), for example, organic small-molecule light-emitting materials, complex light-emitting materials, or polymers. For example, FIG. 5 is a diagram of a partial structure of the display panel 10 cut in the thickness direction according to an embodiment of this application. In addition to the light-emitting subpixel 103, the light-emitting layer 1 of the display panel 10 further includes a related structure for implementing light emission in the display panel 10. For example, the light-emitting layer 1 further includes a substrate 104, anodes and cathodes (not shown in the figure) on two sides of the first light-emitting portion 131 and the second light-emitting portion 132, a pixel definition layer (pixel define layer, PDL) 105, and the like. Both the light-emitting subpixel 103 and the pixel definition layer 105 are disposed on the substrate 104. The substrate 104 is made of any material such as glass, ceramic, plastic, metal, or rubber. This is not limited in this application. For example, the substrate 104 is made of a flexible material, for example, a polyimide material, so that the substrate 104 can be bent and deformed. The display panel 10 using the substrate 104 can satisfy a requirement for use of a foldable electronic device 1000.

In some embodiments, the pixel definition layer 105 is made of an opaque material, and a plurality of opening areas are formed in the pixel definition layer 105. Each opening area corresponds to the first light-emitting portion 131 and the second light-emitting portion 132 of the light-emitting subpixel 103. The anodes that are of the first light-emitting portion 131 and the second light-emitting portion 132 and that are connected to the pixel control circuit 101 are disposed on a side that is of the first light-emitting portion 131 and the second light-emitting portion 132 and that faces the substrate 104, and are located in the opening areas defined in the pixel definition layer. The cathodes of the first light-emitting portion 131 and the second light-emitting portion 132 are disposed on a side that is of the first light-emitting portion 131 and the second light-emitting portion 132 and that faces away from the substrate 104, and the cathodes are at least sufficiently light-transmissive, so that light emitted by the first light-emitting portion 131 and the second light-emitting portion 132 can exit through the corresponding cathodes.

In some embodiments, the display panel 10 further includes a packaging layer 2 disposed on the light exit side of the light-emitting layer 1. The packaging layer 2 is used for packaging and protection for the light-emitting layer 1, and enables the light exit side of the light-emitting layer 1 to have a flat surface, to facilitate processing and arrangement of another structure. In some embodiments, the packaging layer 2 includes a first inorganic layer, an organic layer, and a second inorganic layer.

In some embodiments, the display panel 10 further includes a touch layer 3, and the touch layer 3 includes a related structure for implementing a touch function of the display panel 10. In some possible implementations, the touch layer 3 implements touch on the display panel 10 by using a mutual-capacitance touch technology, or the touch layer 3 implements touch on the display panel 10 by using a self-capacitance touch technology. For example, the touch layer 3 may include an insulation layer, and a first wiring layer and a second wiring layer that are spaced apart. The insulation layer may be made of an inorganic insulation material such as silicon nitride or silicon oxide, or may be made of an organic insulation material such as a polymer organic material or a resin material. The insulation layer made of the inorganic insulation material is widely used in the display panel 10 due to lightness and thinness. In some embodiments, the first wiring layer and the second wiring layer may be different electrodes (for example, one is an Rx electrode, and the other is a Tx electrode), and the two electrodes are located at two layers respectively. This design may be referred to as a bridge-free touch solution.

As shown in FIG. 5, in some possible embodiments, the light-absorbing layer 4 further includes a planarization layer 402. The planarization layer 402 covers a side that is of the light-absorbing portion 401 and that faces away from the light-emitting layer 1. The planarization layer 402 can perform planarization processing (or referred to as leveling processing) on a side that is of the light-absorbing layer 4 and that faces away from the light-emitting layer 1, to facilitate formation of a subsequent structure on a light exit side of the planarization layer 402, for example, facilitate arrangement of a polarizer on the light exit side of the planarization layer 402, or facilitate formation of a microlens on the light exit side of the planarization layer 402.

In some embodiments, the planarization layer 402 includes a first planarization layer 402 and a second planarization layer 402, the first planarization layer 402 covers the first light-absorbing portion 411, the second light-absorbing portion 412 is formed on a light exit side of the first planarization layer 402, and the second planarization layer 402 covers the second light-absorbing portion 412. In this way, the first planarization layer 402 enables the side that is of the first light-absorbing portion 411 and that faces away from the light-emitting layer 1 to be a flat surface, to facilitate subsequent formation of the second light-absorbing portion 412, and the second planarization layer 402 enables a side that is of the second light-absorbing portion 412 and that faces away from the light-emitting layer 1 to be a flat surface, to facilitate disposing of a subsequent structure (for example, the polarizer or the microlens).

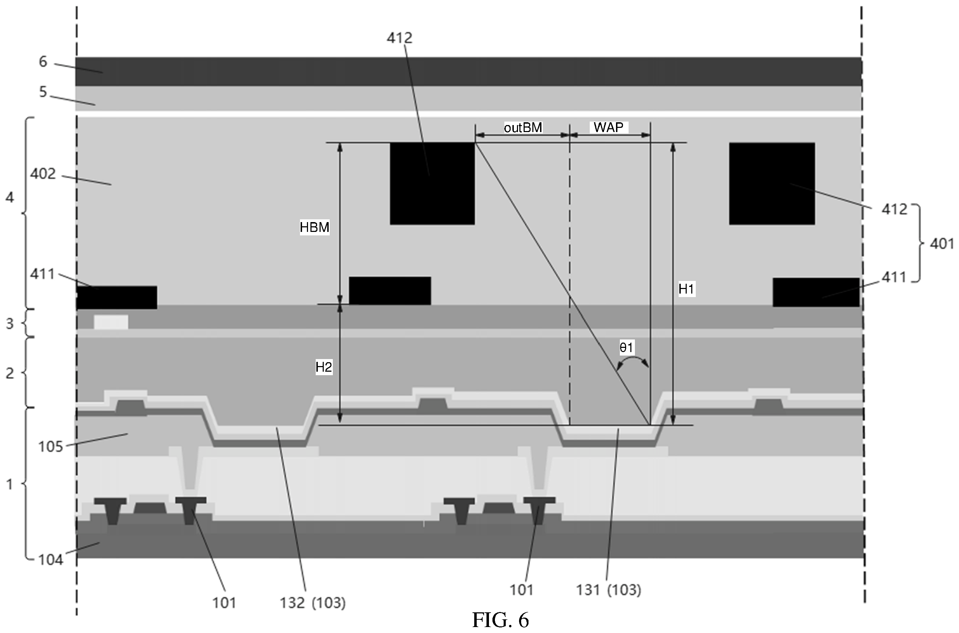

FIG. 6 is a partial diagram of the display panel 10 in the thickness direction according to an implementation of this application. The display panel 10 satisfies the following relationship:$θ 1 \geq arcsin \left(sinα/N\right)$

α is the first light emission angle. For example, the first light emission angle ranges from 30° to 60°. A first critical angle θ1 is an included angle between the thickness direction and a connection line between an end portion that is of the first light-emitting portion 131 and that is away from the second light-absorbing portion 412 in the first direction and an end portion, close to the first light-emitting portion 131, on an end surface that is of the second light-absorbing portion 412 and that faces away from the light-emitting layer 1. N is an average refractive index. The average refractive index N herein is a ratio of a sine value of an emission angle of light to a sine value of an included angle between the thickness direction and the light in a case in which the light exits from the first light-emitting portion 131. The average refractive index N reflects a deflection rate of light emitted by the first light-emitting portion 131 after the light exits from a light exit surface. It should be noted that the light emitted by the first light-emitting portion 131 is refracted when passing through a subsequent structural layer (for example, the packaging layer 2, the touch layer 3, or the planarization layer 402). Materials of structural layers are different, and refractive indexes of the structural layers are also different. Therefore, the average refractive index N may be obtained through calculation based on a refractive index of a specific structural layer in the display panel 10, or the average refractive index N may be obtained through light simulation experiment. For example, in an embodiment in which the display panel 10 includes the packaging layer 2, the packaging layer 2 is located on a light exit surface of the light-emitting layer 1, and the average refractive index N is equal to a refractive index of the packaging layer 2.

The display panel 10 in the foregoing embodiments further satisfies the following relationship: $\left(WAP+outBM\right) / \left(H1\right) > tan \left(θ1\right)$

WAP is a size of the first light-emitting portion 131 in the first direction, and outBM is a spacing between the first light-emitting portion 131 and the light-absorbing portion 401 in the first direction. For example, in an implementation in which the light-absorbing portion includes the first light-absorbing portion 411 and the second light-absorbing portion 412, outBM is a spacing between the first light-emitting portion 131 and the second light-absorbing portion 412 in the first direction, and H1 is a spacing, in the thickness direction, between the first light-emitting portion 131 and an end that is of the second light-absorbing portion 412 and that faces away from the light-emitting layer 1.

Refer to FIG. 6. When light exits from the first light-emitting portion 131 at an angle greater than the first critical angle θ1, the light greater than the first critical angle θ1 is absorbed by the second light-absorbing portion 412. In this case, the light greater than the first critical angle θ1 cannot exit from a light exit surface of the display panel 10. This eliminates light greater than the first light emission angle on the light exit surface of the display panel 10, and reduces a visible range of the display panel 10, to improve the anti-peeping property. According to the foregoing relational expression, after the first light emission angle α, the average refractive index N, and the size of the first light-emitting portion 131 in the first direction are determined, the following may be obtained: the spacing outBM between the first light-emitting portion 131 and the second light-absorbing portion 412 in the first direction and the spacing H1, in the thickness direction, between the first light-emitting portion 131 and the end that is of the second light-absorbing portion 412 and that faces away from the light-emitting layer 1. In this way, a position and a size of the second light-absorbing portion 412 can be designed to satisfy a light-absorbing requirement.

In the foregoing embodiments, for example, the display panel 10 satisfies the following relationship: H1 = H2 + HBM. HBM is a spacing, in the thickness direction, between the end surface that is of the second light-absorbing portion 412 and that faces away from the light-emitting layer 1 and an end surface that is of the first light-absorbing portion 411 and that faces the light-emitting layer 1. H2 is a spacing, in the thickness direction, between the first light-emitting portion 131 and the end surface that is of the first light-absorbing portion 411 and that faces the light-emitting layer 1. For example, in an embodiment in which the display panel 10 includes the packaging layer 2 and the touch layer 3, H2 is a spacing between a light exit surface of the touch layer 3 and the first light-emitting portion 131 in the thickness direction.

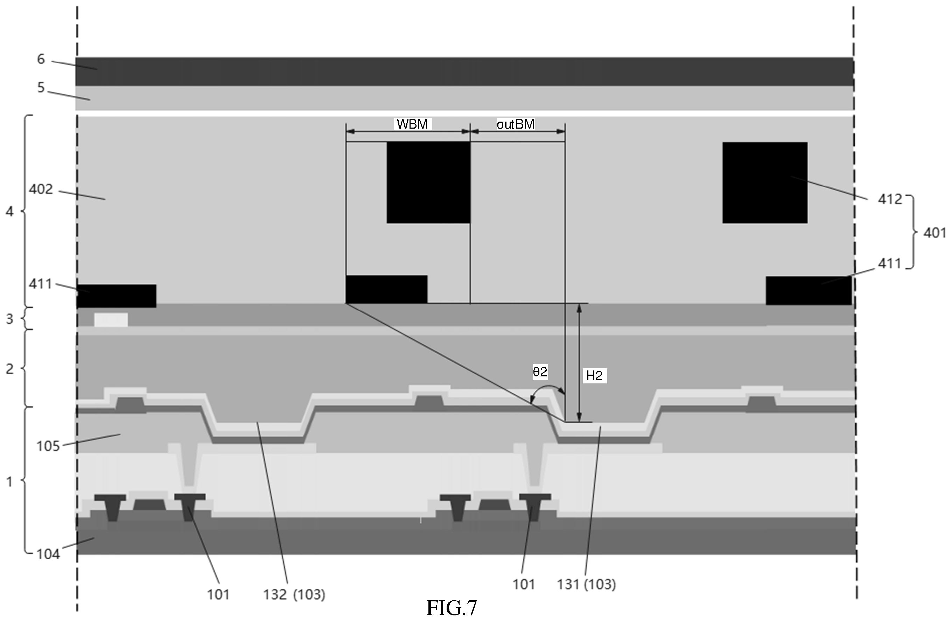

As shown in FIG. 7, in some possible implementations, the display panel 10 further satisfies the following relationship: $θ 2 \geq arcsin \left(sinβ/N\right)$

β is a critical emission angle. It should be noted that when an emission angle of light is greater than the critical emission angle, the light is totally reflected in the display panel 10 and cannot exit from the display panel 10. Generally, the critical emission angle β is 90°. A second critical angle θ2 is an included angle between the thickness direction and a connection line between an end portion that is of the first light-emitting portion 131 and that is close to the first light-absorbing portion 411 in the first direction and an end portion, away from the first light-emitting portion 131, on the end surface that is of the first light-absorbing portion 411 and that faces the light-emitting layer 1, and N is an average refractive index.

In the foregoing embodiments, when light that is emitted by the first light-emitting portion 131 and that is greater than the second critical angle θ2 exits into the light exit surface of the display panel 10, an emission angle corresponding to the light is greater than the critical emission angle. In this case, the light is totally reflected in the display panel 10 and cannot exit from the display panel 10. This can prevent the light from interfering with display effect of the display panel 10.

For example, with reference to FIG. 7, the display panel 10 further satisfies the following relationship: $\left(outBM+WBM\right) / \left(H2\right) > tan \left(θ2\right)$

outBM is the spacing between the first light-emitting portion 131 and the light-absorbing portion 401 in the first direction, and WBM is a size of the light-absorbing portion 401 between the first light-emitting portion 131 and the second light-emitting portion 132 in the first direction. For example, in the implementation in which the light-absorbing portion 401 includes the first light-absorbing portion 411 and the second light-absorbing portion 412, outBM is the spacing between the first light-emitting portion 131 and the second light-absorbing portion 412 in the first direction, and WBM is an overall size of the first light-absorbing portion 411 and the second light-absorbing portion 412 in the first direction. H2 is a spacing, in the thickness direction, between the first light-emitting portion 131 and an end surface that is of the light-absorbing portion 401 and that faces the light-emitting layer 1. For example, H2 is the spacing, in the thickness direction, between the first light-emitting portion 131 and the end surface that is of the first light-absorbing portion 411 and that faces the light-emitting layer 1. In the embodiment in which the display panel 10 includes the packaging layer 2 and the touch layer 3, H2 is the spacing between the light exit surface of the touch layer 3 and the first light-emitting portion 131 in the thickness direction.

Refer to FIG. 7 to FIG. 9. A value of outBM + WBM is equal to a sum of a spacing between the first light-emitting portion 131 and the first light-absorbing portion 411 and a size of the first light-absorbing portion 411 in the first direction. Therefore, the foregoing formula may also be expressed as: $\left(outBM1+WBM1\right) / \left(H2\right) > tan \left(θ2\right)$

outBM1 is a spacing between the first light-emitting portion 131 and the first light-absorbing portion 411 in the first direction, and WBM1 is the size of the first light-absorbing portion 411 in the first direction.

As shown in FIG. 7, in the foregoing embodiments, when light emitted by the first light-emitting portion 131 exits at an angle greater than the second critical angle θ2, an emission angle corresponding to the light is greater than the critical emission angle. In this case, the light is totally reflected in the display panel 10 and cannot exit from the display panel 10. When light exits from the first light-emitting portion 131 at an angle less than the second critical angle θ2, all light less than the second critical angle θ2 can be absorbed by the first light-absorbing portion 411. This eliminates light greater than the first light emission angle on the light exit surface of the display panel 10, and reduces the visible range of the display panel 10, to improve the anti-peeping property.

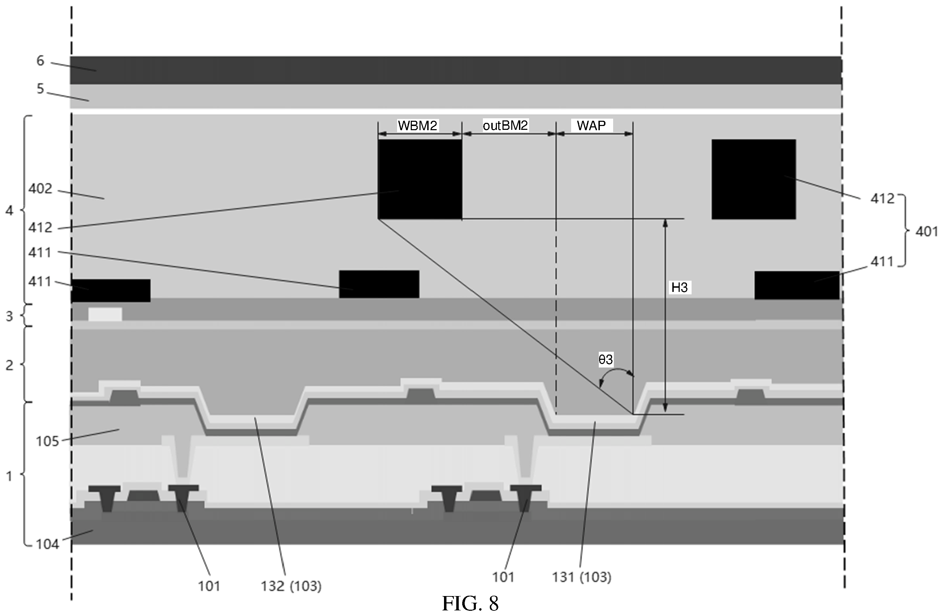

As shown in FIG. 8, in some possible implementations, the display panel 10 satisfies the following relationship: $θ 3 \geq arcsin \left(sinβ/N\right)$

β is a critical emission angle. For example, β = 90°. A third critical angle θ3 is an included angle between the thickness direction and a connection line between the end portion that is of the first light-emitting portion 131 and that is away from the second light-absorbing portion 412 in the first direction and an end portion, away from the first light-emitting portion 131, on an end surface that is of the second light-absorbing portion 412 and that faces the light-emitting layer 1, and N is an average refractive index.

In the foregoing embodiments, the display panel 10 further satisfies the following relationship: $\left(WAP+outBM2+WBM2\right) / \left(H3\right) > tan \left(θ3\right)$

WAP is the size of the first light-emitting portion 131 in the first direction, outBM2 is the spacing between the first light-emitting portion 131 and the second light-absorbing portion 412 in the first direction, WBM2 is a size of the second light-absorbing portion 412 in the first direction, and H3 is a spacing, in the thickness direction, between the first light-emitting portion 131 and the end surface that is of the second light-absorbing portion 412 and that faces the light-emitting layer 1.

In the embodiments, when light that is emitted by the first light-emitting portion 131 and that is greater than the third critical angle θ3 exits into the light exit surface of the display panel 10, an emission angle corresponding to the light is greater than the critical emission angle. In this case, the light is totally reflected in the display panel 10 and cannot exit from the display panel 10. This can prevent the light from interfering with display effect of the display panel 10.

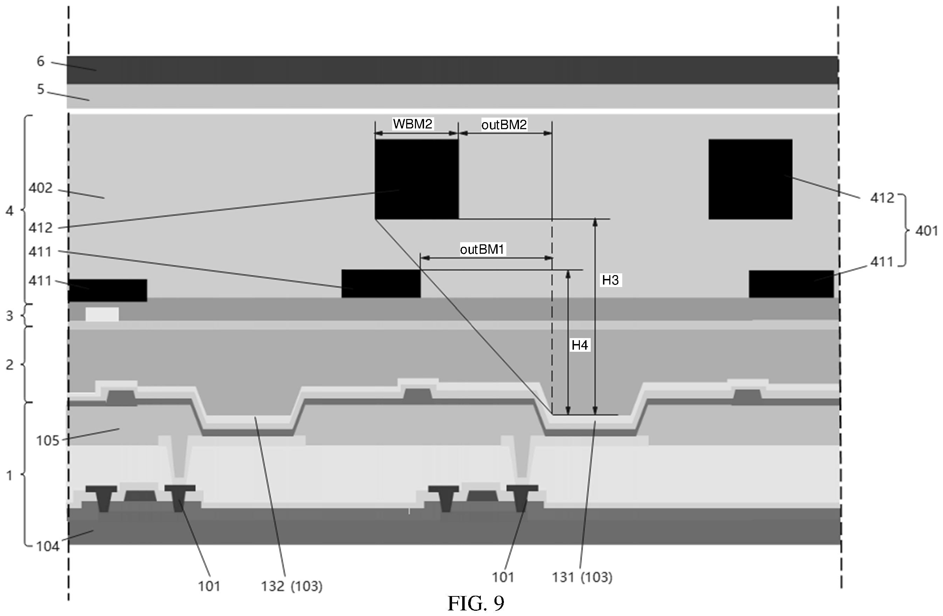

As shown in FIG. 9, in some example implementations, the display panel 10 further satisfies the following relationship: $arctan \left(outBM1/H4\right) \leq arctan \left(\left(outBM2+WBM2\right)/\left(H3\right)\right)$

outBM1 is the spacing between the first light-absorbing portion 411 and the first light-emitting portion 131 in the first direction, outBM2 is the spacing between the second light-absorbing portion 412 and the first light-emitting portion 131 in the first direction, WBM2 is the size of the second light-absorbing portion 412 in the first direction, H3 is the spacing, in the thickness direction, between the first light-emitting portion 131 and the end surface that is of the second light-absorbing portion 412 and that faces the light-emitting layer 1, and H4 is a spacing, in the thickness direction, between the first light-emitting portion 131 and an end surface that is of the first light-absorbing portion 411 and that faces away from the light-emitting layer 1. In the foregoing embodiments, light that is emitted by the first light-emitting portion 131 and that is less than the second critical angle θ2 and greater than the first critical angle θ1 can be completely absorbed by the first light-absorbing portion 411 or the second light-absorbing portion 412, so that the light does not exit from the first light-absorbing portion 411 and the second light-absorbing portion 412. This ensures that the light-absorbing portion 401 has a good rate for absorbing light greater than the first light emission angle.

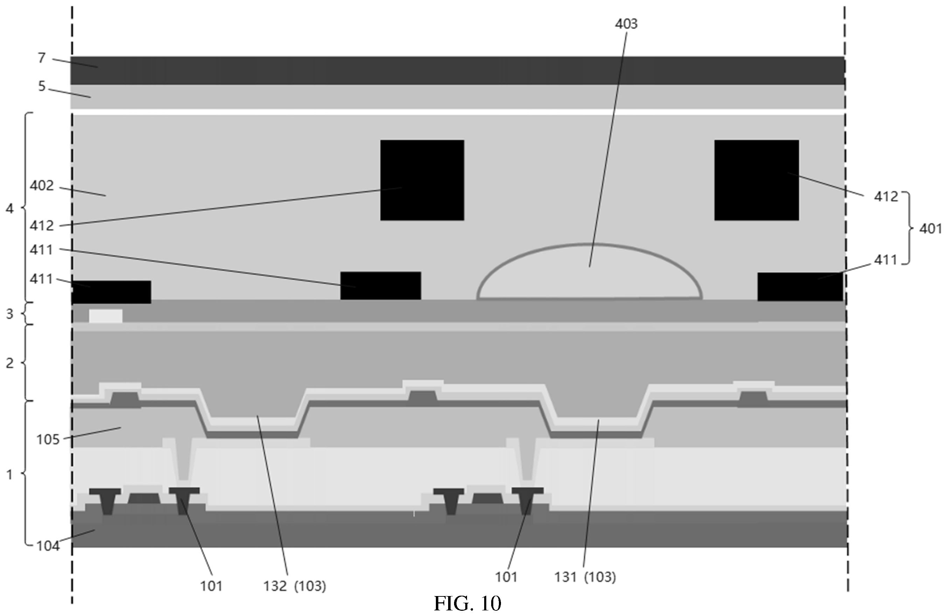

In some possible embodiments, as shown in FIG. 10, the display panel 10 further includes a microlens 403, the microlens 403 is disposed corresponding to the first light-emitting portion 131 and is located on a light exit side of the first light-emitting portion 131, and an orthographic projection of the microlens 403 in the thickness direction at least partially overlaps the first light-emitting portion 131. The microlens 403 can converge light. When light emitted by the first light-emitting portion 131 passes through the microlens 403 corresponding to the first light-emitting portion 131, the light can at least partially converge toward a normal (an axis or a center line) of the microlens 403. The microlens 403 converges the light emitted by the first light-emitting portion 131 corresponding to the microlens 403, so that the light can be more concentrated. This helps the light exit from the light-absorbing layer 4, to improve light exit efficiency of the light emitted by the first light-emitting portion 131. During actual application, a position of the microlens 403 may be adaptively adjusted according to a light exit path of the first light-emitting portion 131, to cover the light exit path of the first light-emitting portion 131 as comprehensively as possible.

In some embodiments, the first light-absorbing portion 411 is located on a light exit side of the microlens 403, and light emitted by the first light-emitting portion 131 can first be converged by the microlens 403 and then pass through the light-absorbing layer 4. It is easier for the converged light to pass through the light-absorbing layer 4, so that light exit efficiency is improved. In some other embodiments, the microlens 403 and the first light-absorbing portion 411 are arranged at a same layer, and the microlens 403 is located in the opening 4111 that is on the first light-absorbing portion 411 and that corresponds to the first light-emitting portion 131. The microlens 403 can converge light, and the microlens 403 does not occupy a separate structural layer. This helps simplify a structure of the display panel 10. In some other embodiments, the microlens 403 is located on the side that is of the first light-absorbing portion 411 and that faces away from the light-emitting layer 1, and the second light-absorbing portion 412 is located on the light exit side of the microlens 403.

For the display panel 10, when external ambient light enters the display panel 10 and is reflected, the user cannot clearly view the content on the display panel 10. To reduce impact of the ambient light on the displayed content of the display panel 10, in some solutions, as shown in FIG. 5 to FIG. 10, the display panel 10 is provided with a polarizer, and the polarizer is located on a light exit side of the light-absorbing layer 4. The polarizer is configured to absorb ambient light emitted into the display panel 10, to prevent reflected ambient light from exiting the display panel 10 and affecting the displayed content.

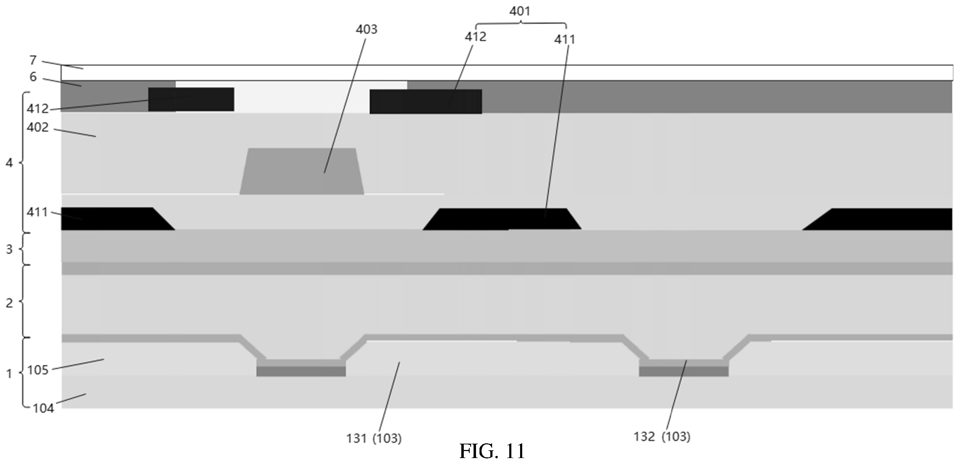

In some other solutions, the industry proposes a color filter on thin film encapsulation (color filter on thin film encapsulation, CF on TFE, COE) technology. The COE technology is a new technology that can replace the polarizer. A color filter is manufactured on a thin film encapsulation (thin film encapsulation, TFE) layer, and a feature of the color filter of transmitting light of a specific spectrum and absorbing light of another spectrum is used to suppress ambient light, so that the content of the display panel 10 can be clear in a strong light environment such as an outdoor environment. For example, the display panel 10 includes a microlens 6, and the microlens 6 is located on the light exit side of the light-absorbing layer 4. Alternatively, as shown in FIG. 11, the microlens 6 and the second light-absorbing portion 412 are arranged at a same layer, to reduce an overall thickness of the display panel 10.

In some embodiments, the display panel 10 further includes a cover 7, and the cover 7 is located on a light exit side of the polarizer or the microlens 6. The cover 7 can provide support and protection for the display panel 10. The cover 7 herein may be a glass cover 7 or a flexible thin film cover 7 (for example, a transparent polyimide cover 7), or the like.

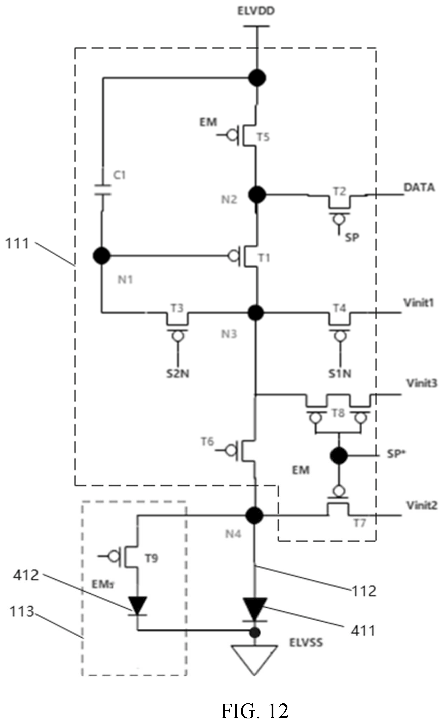

As shown in FIG. 12, in some possible implementations, the pixel control circuit 101 includes a main control circuit 111, and a first branch 112 and a second branch 113 that are connected in parallel, an output of the main control circuit 111 is separately electrically connected to an input of the first branch 112 and an input of the second branch 113, the first light-emitting portion 131 is disposed on the first branch 112, and a transistor switch T9 and the second light-emitting portion 132 that are connected in series are disposed on the second branch 113.

In the foregoing embodiments, when the transistor switch T9 on the second branch 113 is turned off, the display panel 10 is in the first state, and the main control circuit 111 is connected to the first light-emitting portion 131, to control the first light-emitting portion 131 to emit light, so that the display panel 10 has the anti-peeping property on the first side. When the transistor switch T9 on the second branch 113 is in an on state, the display panel 10 is in the second state, and the main control circuit 111 is separately connected to the first light-emitting portion 131 and the second light-emitting portion 132, to control both the first light-emitting portion 131 and the second light-emitting portion 132 to emit light, so that the display panel 10 has the sharing property.

In addition, because the first branch 112 and the second branch 113 are connected in parallel, when the transistor switch T9 is turned on, an input current of the main control circuit 111 is divided on the first branch 112 and the second branch 113. In comparison with a use state in which the transistor switch T9 is turned off, a current of the first branch 112 decreases, and brightness of the first light-emitting portion 131 diminishes as the current decreases. This helps prolong a service life of the first light-emitting portion 131, and prevents the display panel 10 from being excessively bright when both the second light-emitting portion 132 and the first light-emitting portion 131 emit light, so that the display panel 10 maintains close display brightness in the first state and the second state.

As shown in FIG. 12, for example, the main control circuit 111 is an 8T1C circuit. The 8T1C circuit is a circuit formed by eight T1C units. T1C is a dual-transmitter circuit capable of storing and processing charges. Each T1C unit includes one transmitter and one capacitor. In the 8T1C circuit, the eight T1C units are combined according to a specific connection mode to form a whole circuit. The 8T1C circuit may be configured to store and process data, to implement functions of controlling restoration, compensation, and light emission of the light-emitting subpixel 103. The 8T1C pixel circuit has features such as continuous light emission, low power consumption, and long life of a light-emitting component, and has become the mainstream for implementing high-quality OLED display panels.

For example, the transistor switch T9 is one of a hydrogenated amorphous silicon (a-Si:H) transistor switch T9, a low-temperature poly-Si (low-temperature poly-Si, LTPS) transistor switch T9, or an amorphous oxide (AOS) transistor switch T9.

In some example implementations, the display panel 10 includes a plurality of light-emitting subpixels 103, the plurality of light-emitting subpixels 103 may form a plurality of pixel groups 102, and each pixel group 102 includes at least one red light-emitting subpixel, at least one green light-emitting subpixel, and at least one blue light-emitting subpixel. In this case, each pixel group 102 includes light-emitting subpixels 103 of three colors, and the pixel group 102 can adjust the red light-emitting subpixel, the green light-emitting subpixel, and the blue light-emitting subpixel in the pixel group 102 according to a three-color ratio, to display different colors at a position of the pixel group 102. It should be noted that, the pixel group 102 is not limited to a fixed combination manner, but means that any light-emitting subpixel 103 can form a pixel group 102 with adjacent light-emitting subpixels 103 of the other two colors. For example, for a first red light-emitting subpixel, a first green light-emitting subpixel, a first blue light-emitting subpixel, and a second red light-emitting subpixel that are adjacently arranged, the first red light-emitting subpixel, the first green light-emitting subpixel, and the first blue light-emitting subpixel form a pixel group 102, and the first green light-emitting subpixel, the first blue light-emitting subpixel, and the second red light-emitting subpixel also form a pixel group 102.

A plurality of light-emitting subpixels 103 in each pixel group 102 may be arranged in a plurality of manners. In some embodiments, each pixel group 102 includes one red light-emitting subpixel, one green light-emitting subpixel, and one blue light-emitting subpixel that are arranged in a triangle. The red light-emitting subpixel, the green light-emitting subpixel, and the blue light-emitting subpixel are arranged in the triangle, so that adjacent pixel groups 102 can share at least one light-emitting subpixel. This helps improve resolution of the display panel 10.

In some other embodiments, each pixel group 102 includes one red light-emitting subpixel, two green light-emitting subpixels, and one blue light-emitting subpixel, and the red light-emitting subpixel, the two green light-emitting subpixels, and the blue light-emitting subpixel are arranged in a quadrilateral. The two green light-emitting subpixels are included in the pixel group 102, so that when one of the green light-emitting subpixels fails, the other green light-emitting subpixel can still provide green light. This helps prolong a service life of the display panel 10. In addition, adjacent pixel groups 102 can share at least two light-emitting subpixels (for example, share the two green light-emitting subpixels), which helps improve resolution of the display panel 10.

For ease of understanding, the following describes specific embodiments of the display panel 10 in this application with reference to the accompanying drawings.

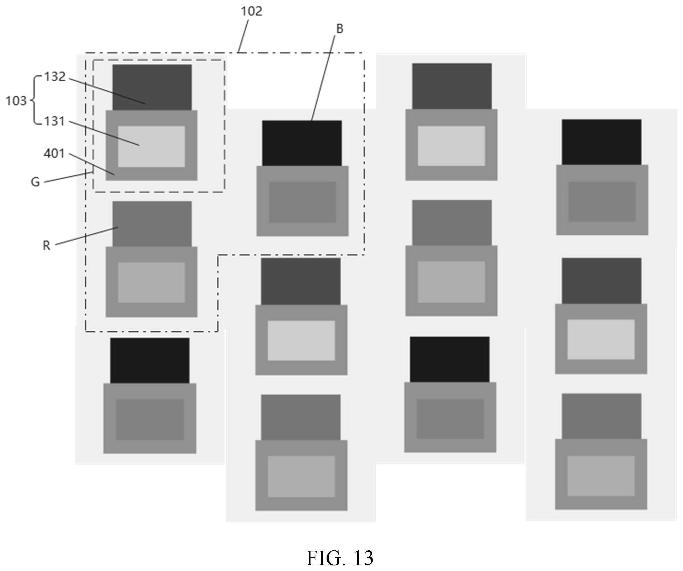

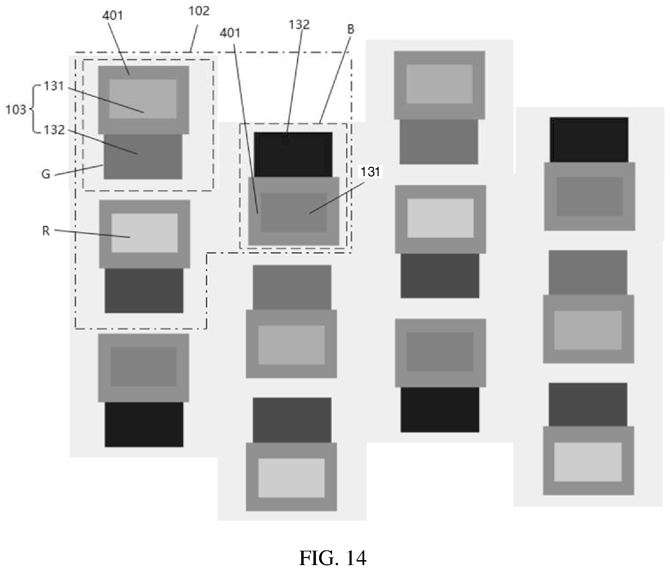

FIG. 2 shows Embodiment 1 of this application. FIG. 13 and FIG. 14 respectively show Embodiment 2 and Embodiment 3 of this application. Embodiment 1, Embodiment 2, and Embodiment 3 all have the following features: The first light-emitting portion 131 and the second light-emitting portion 132 are sequentially arranged in the first direction, both the first light-emitting portion 131 and the second light-emitting portion 132 are rectangular light-emitting portions, the second light-absorbing portion 402 is an annular light-absorbing portion, and the annular light-absorbing portion is disposed around the first light-emitting portion 131. In the display panel 10 in the foregoing embodiments, the pixel group 102 includes a red light-emitting subpixel, a green light-emitting subpixel, and a green light-emitting subpixel that are arranged in a triangle.

In Embodiment 1, as shown in FIG. 2, a projection of the second light-absorbing portion 412 onto the light-emitting layer 1 in the thickness direction is spaced from the second light-emitting portion 132. The second light-absorbing portion 412 has little impact on light of the second light-emitting portion 132, to ensure a wide visible range of the light of the second light-emitting portion 132. In addition, the second light-emitting portion 132 in each light-emitting subpixel 103 is located on the second side of the corresponding first light-emitting portion 131. For example, in a scenario of application to a personal computer, the first direction is a top-bottom direction of the display panel 10 in a use state, and the second side of the display panel 10 is a side that is of the display panel 10 and that is close to a computer keyboard.

In Embodiment 2, as shown in FIG. 13, a projection of the second light-absorbing portion 412 onto the light-emitting layer 1 in the thickness direction is close to the second light-emitting portion 132, so that a structure of the light-emitting subpixel 103 is more compact, which helps improve resolution of the display panel 10.

In Embodiment 3, as shown in FIG. 14, light-emitting subpixels 103 in the pixel group 102 are divided into two columns. The second light-emitting portion 132 of the light-emitting subpixel 103 in one column is located on the first side of the corresponding first light-emitting portion 131, and the second light-emitting portion 132 of the light-emitting subpixel 103 in the other column is located on the second side of the corresponding first light-emitting portion 131. In this case, relative positions of first light-emitting portions 131 and second light-emitting portions 132 of light-emitting subpixels 103 in different columns are opposite. This helps implement light compensation on the two sides, and avoids an excessively large difference between light amounts on the first side and the second side, so that the display panel 10 has close brightness on the first side and the second side.

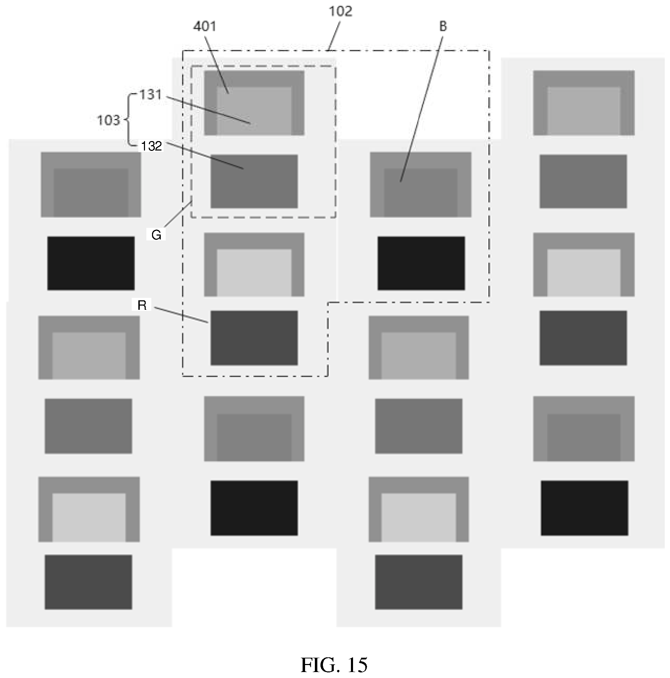

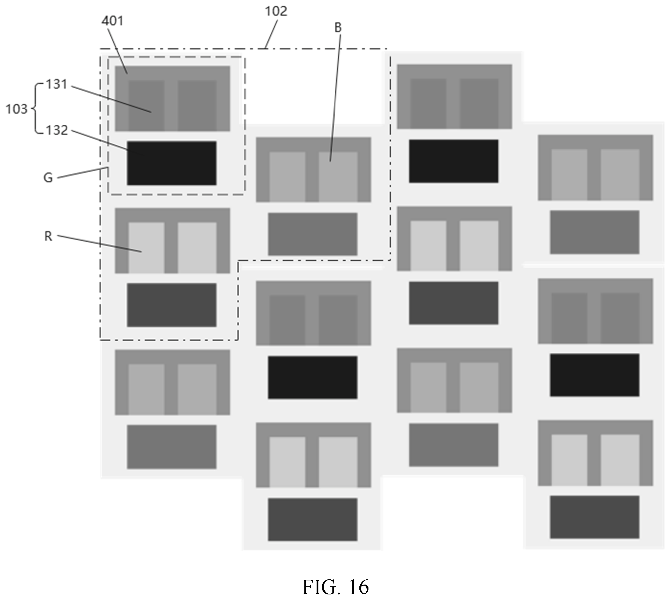

FIG. 15 and FIG. 16 respectively show Embodiment 4 and Embodiment 5 of this application. Both Embodiment 4 and Embodiment 5 have the following features: The first light-emitting portion 131 and the second light-emitting portion 132 are sequentially arranged in the first direction, both the first light-emitting portion 131 and the second light-emitting portion 132 are rectangular light-emitting portions, and an orthographic projection of the second light-absorbing portion 412 onto the light-emitting layer 1 is separately located on the first side, the third side, and the fourth side of the first light-emitting portion 131. For example, in a scenario of application to a personal computer, the first direction is a top-bottom direction of the display panel 10 in a use state, and the second side of the display panel 10 is a side that is of the display panel 10 and that is close to a computer keyboard. There is little need for anti-peeping on the second side and therefore no need to dispose the second light-absorbing portion 412 on the second side, so that a processing process can be simplified. In Embodiment 5, as shown in FIG. 16, the first light-emitting portion 131 may be divided into two light-emitting sub-portions, and the orthographic projection of the second light-absorbing portion 412 onto the light-emitting layer 1 is at least partially located between the two light-emitting sub-portions. This can further improve the anti-peeping property on the third side and the fourth side.

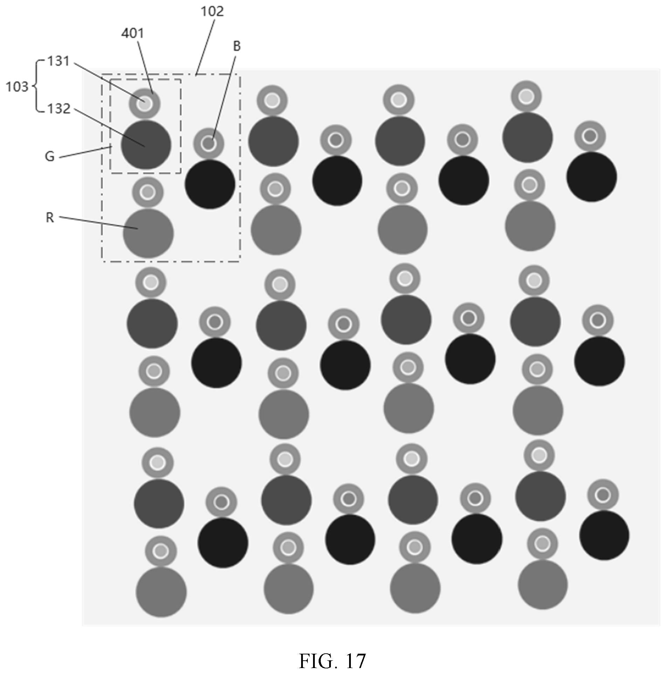

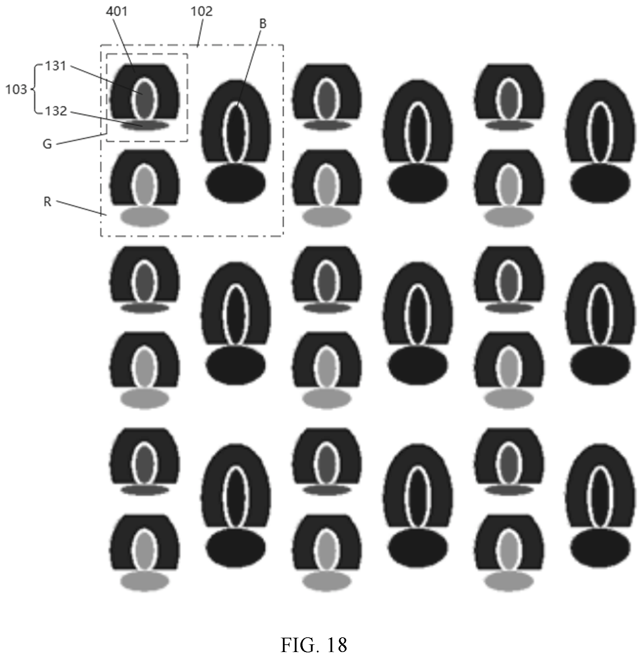

FIG. 17 and FIG. 18 respectively show Embodiment 6 and Embodiment 7 of this application. The first light-emitting portion 131 and the second light-emitting portion 132 are sequentially arranged in the first direction. In Embodiment 6, as shown in FIG. 7, the first light-emitting portion 131 and the second light-emitting portion 132 are circular light-emitting portions, and the second light-absorbing portion 412 is a circular-ring light-absorbing portion. In Embodiment 7, as shown in FIG. 8, the first light-emitting portion 131 and the second light-emitting portion 132 are elliptical light-emitting portions, a major axis of the first light-emitting portion 131 is perpendicular to a major axis of the second light-emitting portion 132, and an orthographic projection of the second light-absorbing portion 412 onto the light-emitting layer 1 is separately located on the first side, the third side, and the fourth side of the first light-emitting portion 131.

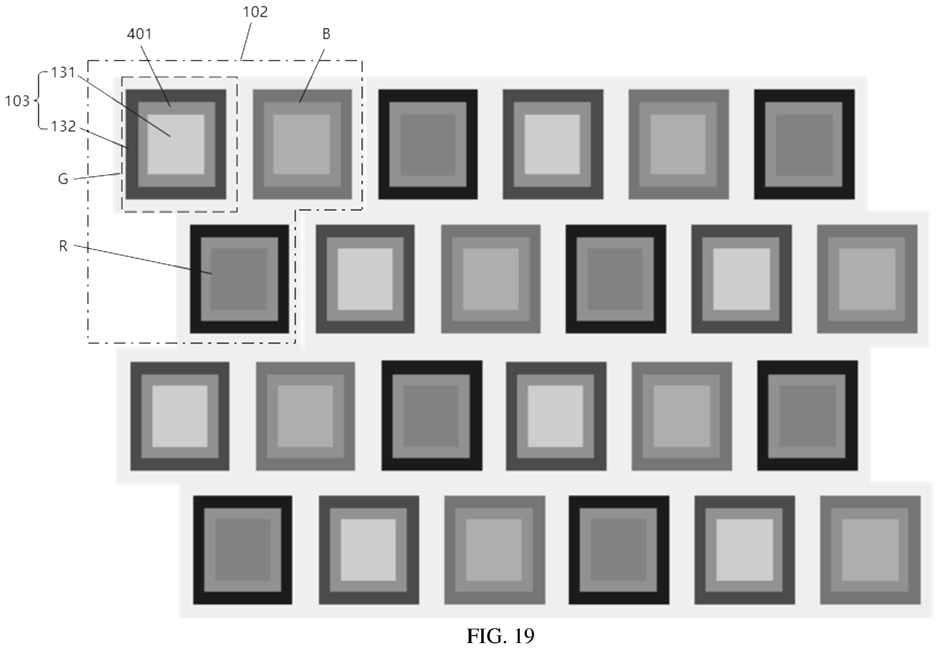

FIG. 19 to FIG. 22 respectively show Embodiment 8, Embodiment 9, Embodiment 10, and Embodiment 11 of this application. Embodiment 8, Embodiment 9, Embodiment 10, and Embodiment 11 all have the following features: The second light-emitting portion 132 is an annular light-emitting portion, the second light-absorbing portion 412 is an annular light-absorbing portion, the annular light-absorbing portion is disposed around the first light-emitting portion 131, and the second light-emitting portion 132 is disposed around the second light-absorbing portion 412 and the first light-absorbing portion 411. In Embodiment 8 and Embodiment 9, the first light-emitting portion 131 is a rectangular light-emitting portion, and the second light-emitting portion 132 is a rectangular-ring light-emitting portion.

In the pixel group 102 in Embodiment 8, a plurality of light-emitting subpixels 103 are arranged in a triangle. In the pixel group 102 in Embodiment 9, a plurality of light-emitting subpixels 103 are arranged in a quadrilateral. In Embodiment 10 and Embodiment 11, the first light-emitting portion 131 is a circular light-emitting portion, and the second light-emitting portion 132 is a circular-ring light-emitting portion. In the pixel group 102 in Embodiment 10, a plurality of light-emitting subpixels 103 are arranged in a triangle. In the pixel group 102 in Embodiment 11, a plurality of light-emitting subpixels 103 are arranged in a quadrilateral.

Based on the display panel 10 provided in the foregoing implementations, this application further provides a manufacturing method for the display panel 10. The manufacturing method includes:
forming a light-emitting layer 1, where the light-emitting layer 1 includes a pixel control circuit 101 and a light-emitting subpixel 103, the light-emitting subpixel 103 includes a first light-emitting portion 131 and a second light-emitting portion 132, and the pixel control circuit 101 is electrically connected to the first light-emitting portion 131 and the second light-emitting portion 132 to selectively turn on the first light-emitting portion 131 and/or the second light-emitting portion 132; and
forming a light-absorbing layer 4, where the light-absorbing layer 4 is disposed on a light exit side of the light-emitting layer 1, the light-absorbing layer 4 includes a first light-absorbing portion 411 and a second light-absorbing portion 412, a plurality of openings 4111 are formed on the first light-absorbing portion 411, orthographic projections of the plurality of openings 4111 in a thickness direction of the display panel 10 cover the first light-emitting portion 131 and the second light-emitting portion 132, the second light-absorbing portion 412 is located on a side that is of the first light-absorbing portion 411 and that faces away from the light-emitting layer 1, and the second light-absorbing portion 412 is at least partially located on a first side that is of the first light-emitting portion 131 and that is in a first direction perpendicular to the thickness direction, to absorb light that is emitted by the first light-emitting portion 131 on the first side and whose light emission angle is greater than a first light emission angle.

For example, forming the light-emitting layer 1 specifically includes: forming a pixel drive circuit on a substrate 104, forming a pixel definition layer 105 by using a vapor deposition process, and forming the light-emitting subpixel 103 on the pixel definition layer 105.

For example, after forming the light-emitting layer 1, the manufacturing method further includes: forming a packaging layer 2 on the light exit side of the light-emitting layer 1, and forming a touch layer 3 on a light exit side of the packaging layer 2.

For example, forming the light-absorbing layer 4 specifically includes: manufacturing the light-absorbing layer 4 by using a coating and photolithography process. The first light-absorbing portion 411 is manufactured by using the coating and photolithography process, a light exit side of the touch layer 3 and a light exit side of the first light-absorbing portion 411 are coated with a first planarization layer 402, the second light-absorbing portion 412 is manufactured on a light exit side of the first planarization layer 402 by using the coating and photolithography process, and light exit sides of the second light-absorbing portion 412 and the first planarization layer 402 are coated with a second planarization layer 402.

For example, the manufacturing method further includes: sequentially attaching a polarizer and a cover 7 to a light exit side of the light-absorbing layer 4.

The foregoing descriptions are merely some embodiments and implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display panel (10), comprising:
a light-emitting layer (1), comprising a pixel control circuit (101) and a light-emitting subpixel (103), wherein the light-emitting subpixel (103) comprises a first light-emitting portion (131) and a second light-emitting portion (132), and the pixel control circuit (101) is electrically connected to the first light-emitting portion (131) and the second light-emitting portion (132) to selectively turn on the first light-emitting portion (131) and/or the second light-emitting portion (132); and
a light-absorbing layer (4), located on a light exit side of the light-emitting layer (1), wherein the light-absorbing layer (4) comprises a first light-absorbing portion (411) and a second light-absorbing portion (412), the first light-absorbing portion (411) covers the light exit side of the light-emitting layer (1), a plurality of openings (4111) are formed on the first light-absorbing portion (411), orthographic projections of the plurality of openings (4111) in a thickness direction of the display panel (10) cover the first light-emitting portion (131) and the second light-emitting portion (132), the second light-absorbing portion (412) is located on a side that is of the first light-absorbing portion (411) and that faces away from the light-emitting layer (1), and the second light-absorbing portion (412) is at least partially located on a first side that is of the first light-emitting portion (131) and that is in a first direction perpendicular to the thickness direction, to absorb light that is emitted by the first light-emitting portion (131) on the first side and whose light emission angle is greater than a first light emission angle.

2. The display panel (10) according to claim 1, wherein the first light-absorbing portion (411) and the second light-absorbing portion (412) are at least partially staggered in the first direction, and a spacing between the first light-absorbing portion (411) and the first light-emitting portion (131) in the first direction is greater than a spacing between the second light-absorbing portion (412) and the first light-emitting portion (131) in the first direction.

3. The display panel (10) according to claim 1 or 2, wherein the second light-absorbing portion (412) is an annular light-absorbing portion, and an orthographic projection of the annular light-absorbing portion in the thickness direction surrounds the first light-emitting portion (131).

4. The display panel (10) according to any one of claims 1 to 3, wherein the first light-emitting portion (131) and the second light-emitting portion (132) are arranged in the first direction; or
the second light-emitting portion (132) is of an annular structure, and the second light-emitting portion (132) is disposed around the first light-emitting portion (131).

5. The display panel (10) according to any one of claims 1 to 4, wherein the pixel control circuit (101) comprises a main control circuit (111), and a first branch (112) and a second branch (113) that are connected in parallel, an output of the main control circuit (111) is separately electrically connected to an input of the first branch (112) and an input of the second branch (113), the first light-emitting portion (131) is disposed on the first branch (112), and a transistor switch (T9) and the second light-emitting portion (132) that are connected in series are disposed on the second branch (113).

6. The display panel (10) according to any one of claims 1 to 5, wherein the light-absorbing layer (4) comprises a planarization layer (402), and the planarization layer (402) covers a side that is of the first light-absorbing portion (411) and that faces away from the light-emitting layer (1) and a side that is of the second light-absorbing portion (412) and that faces away from the light-emitting layer (1).

7. The display panel (10) according to any one of claims 1 to 6, wherein the display panel (10) comprises a microlens (403), the microlens (403) is disposed corresponding to the first light-emitting portion (131) and is located on a light exit side of the first light-emitting portion (131), and an orthographic projection of the microlens (403) in the thickness direction at least partially overlaps the first light-emitting portion (131).

8. The display panel (10) according to claim 7, wherein the microlens (403) and the first light-absorbing portion (411) are arranged at a same layer, and the microlens (403) is located in the opening (4111) that is on the first light-absorbing portion (411) and that corresponds to the first light-emitting portion (131); or
the microlens (403) is located on the side that is of the first light-absorbing portion (411) and that faces away from the light-emitting layer (1), and the second light-absorbing portion (412) is located on a light exit side of the microlens (403).

9. The display panel (10) according to any one of claims 1 to 8, wherein the display panel (10) comprises a polarizer (5), and the polarizer (5) is located on a light exit side of the light-absorbing layer (4).

10. The display panel (10) according to any one of claims 1 to 8, wherein the display panel (10) comprises a color filter layer (6), and the color filter layer (6) is located on a light exit side of the light-absorbing layer (4), or the color filter layer (6) and the second light-absorbing portion (412) are arranged at a same layer.

11. The display panel (10) according to any one of claims 1 to 10, wherein the light-emitting subpixel (103) comprises a red light-emitting subpixel (R), a green light-emitting subpixel (B), and a blue light-emitting subpixel (G), and the display panel (10) comprises a plurality of pixel groups (102); and
each pixel group (102) comprises one red light-emitting subpixel (R), one green light-emitting subpixel (B), and one blue light-emitting subpixel (G) that are arranged in a triangle, or each pixel group (102) comprises one red light-emitting subpixel (R), two green light-emitting subpixels (G), and one blue light-emitting subpixel (B) that are arranged in a quadrilateral.

12. The display panel (10) according to any one of claims 1 to 11, wherein the first light emission angle ranges from 30° to 60°.

13. The display panel (10) according to any one of claims 1 to 12, wherein the display panel (10) satisfies the following relationship: $θ 1 \geq arcsin \left(sinα/N\right) ,$ wherein
α is the first light emission angle, a first critical angle θ1 is an included angle between the thickness direction and a connection line between an end portion that is of the first light-emitting portion (131) and that is away from the second light-absorbing portion (412) in the first direction and an end portion, close to the first light-emitting portion (131), on an end surface that is of the second light-absorbing portion (412) and that faces away from the light-emitting layer (1), and N is an average refractive index; and
the display panel (10) further satisfies the following relationship: $\left(WAP+outBM2\right) / \left(H1\right) > tan \left(θ1\right) ,$ wherein
WAP is a size of the first light-emitting portion (131) in the first direction, outBM2 is the spacing between the first light-emitting portion (131) and the second light-absorbing portion (412) in the first direction, and H1 is a spacing, in the thickness direction, between the first light-emitting portion (131) and the end surface that is of the second light-absorbing portion (412) and that faces away from the light-emitting layer (1).

14. The display panel (10) according to any one of claims 1 to 13, wherein the display panel (10) satisfies the following relationship: $θ 2 \geq arcsin \left(sinβ/N\right) ,$ wherein
β is a critical emission angle, a second critical angle θ2 is an included angle between the thickness direction and a connection line between an end portion that is of the first light-emitting portion (131) and that is close to the first light-absorbing portion (411) in the first direction and an end portion, away from the first light-emitting portion (131), on an end surface that is of the first light-absorbing portion (411) and that faces the light-emitting layer (1), and N is an average refractive index; and
the display panel (10) further satisfies the following relationship: $\left(outBM1+WBM1\right) / \left(H2\right) > tan \left(θ2\right) ,$ wherein
outBM1 is the spacing between the first light-emitting portion (131) and the first light-absorbing portion (411) in the first direction, WBM1 is a size of the first light-absorbing portion (411) in the first direction, and H2 is a spacing, in the thickness direction, between the first light-emitting portion (131) and the end surface that is of the first light-absorbing portion (411) and that faces the light-emitting layer (1).

15. The display panel (10) according to any one of claims 1 to 14, wherein the display panel (10) satisfies the following relationship: $θ 3 \geq arcsin \left(sinβ/N\right) ,$ wherein
β is a critical emission angle, a third critical angle θ3 is an included angle between the thickness direction and a connection line between the end portion that is of the first light-emitting portion (131) and that is away from the second light-absorbing portion (412) in the first direction and an end portion, away from the first light-emitting portion (131), on an end surface that is of the second light-absorbing portion (412) and that faces the light-emitting layer (1), and N is an average refractive index; and
the display panel (10) further satisfies the following relationship: $\left(WAP+outBM2+WBM2\right) / \left(H3\right) > tan \left(θ3\right) ,$ wherein
WAP is the size of the first light-emitting portion (131) in the first direction, outBM2 is the spacing between the first light-emitting portion (131) and the second light-absorbing portion (412) in the first direction, WBM2 is a size of the second light-absorbing portion (412) in the first direction, and H3 is a spacing, in the thickness direction, between the first light-emitting portion (131) and the end surface that is of the second light-absorbing portion (412) and that faces the light-emitting layer (1).

16. The display panel (10) according to any one of claims 1 to 15, wherein the display panel (10) further satisfies the following relationship: $arctan \left(outBM1/H4\right) \leq arctan \left(\left(outBM2+WBM2\right)/\left(H3\right)\right) ,$ wherein
outBM 1 is the spacing between the first light-absorbing portion (411) and the first light-emitting portion (131) in the first direction, outBM2 is the spacing between the second light-absorbing portion (412) and the first light-emitting portion (131) in the first direction, WBM2 is the size of the second light-absorbing portion (412) in the first direction, H3 is the spacing, in the thickness direction, between the first light-emitting portion (131) and the end surface that is of the second light-absorbing portion (412) and that faces the light-emitting layer (1), and H4 is a spacing, in the thickness direction, between the first light-emitting portion (131) and an end surface that is of the first light-absorbing portion (411) and that faces away from the light-emitting layer (1).

17. A display screen module (100), comprising the display panel (10) according to any one of claims 1 to 16 and a flexible circuit board (20), wherein the flexible circuit board (20) is electrically connected to the display panel (10).

18. An electronic device, comprising:
a control circuit board (30); and
the display screen module (100) according to claim 17, wherein the flexible circuit board (20) in the display screen module (100) is configured to connect the control circuit board (30) to the display panel (10).
